# EUROPEAN PATENT SPECIFICATION

(11) **EP 4 583 659 B1**
(45) Date of publication and mention of the grant of the patent: **02.12.2026**
(21) Application number: 25176032.8
(22) Date of filing: 04.10.2018
(51) Int. Cl.: H10B 12/00

(54) **DEVICES HAVING A TRANSISTOR AND A CAPACITOR ALONG A COMMON HORIZONTAL LEVEL, AND METHODS OF FORMING DEVICES**
VORRICHTUNGEN MIT EINEM TRANSISTOR UND EINEM KONDENSATOR ENTLANG EINER GEMEINSAMEN HORIZONTALEN EBENE UND VERFAHREN ZUR HERSTELLUNG VON VORRICHTUNGEN
DISPOSITIFS AYANT UN TRANSISTOR ET UN CONDENSATEUR LE LONG D'UN NIVEAU HORIZONTAL COMMUN, ET PROCÉDÉS DE FORMATION DE DISPOSITIFS

(30) Priority: 07.12.2017 US 201762595912 P
(43) Date of publication of application: 09.07.2025
(62) Document number(s) of the earlier application(s) in accordance with Art. 76 EPC: 18886252.8 / 3 682 477
(73) Proprietor: Micron Technology, Inc., Boise, ID 83716 (US)
(72) Inventor: FISHBURN, Fredrick D., Hiroshima-shi 730-0005 (JP)
(74) Representative: Marks & Clerk LLP

(56) References cited:
- WO-A1-2018/208717
- US-A1- 2012 161 132
- US-A1- 2013 146 959

## Description

### TECHNICAL FIELD

Devices which have a transistor and a capacitor; and in which the transistor and the capacitor are along a common horizontal level.

### BACKGROUND

Memory is one type of integrated circuitry, and is used in electronic systems for storing data. Integrated memory is usually fabricated in one or more arrays of individual memory cells. The memory cells are configured to retain or store memory in at least two different selectable states. In a binary system, the states are considered as either a "0" or a "1". In other systems, at least some individual memory cells may be configured to store more than two levels or states of information.

An example memory is dynamic random access memory (DRAM). The DRAM unit cells may each comprise a capacitor in combination with a transistor. Charge stored on the capacitors of the DRAM unit cells may correspond to memory bits.

There is a continuing goal to improve architectural layouts of integrated circuit structures in an effort to maintain (or even improve) device performance, while achieving ever higher levels of integration. It is desired to develop improved architectures, and improved devices. It would be desirable for the improved devices to be suitable for utilization in memory and/or in other integrated circuitry. It is further desired to develop methods for fabricating the improved devices and architectures.

US2013/146959A1 discloses a method and structure for forming on-chip high quality capacitors with ETSOI transistors.

WO2018/208717A1 discloses a memory array comprising vertically alternating tiers of insulative material and memory cells.

### SUMMARY

The scope of the invention is defined by the appended claims.

### BRIEF DESCRIPTION OF THE DRAWINGS

FIG. 1 is a diagrammatic three-dimensional view of an example device.
FIG. 2 is another diagrammatic three-dimensional view of the example device of FIG. 1.
FIGS. 3-5 are diagrammatic three-dimensional views of other example devices; FIG. 3 forms part of the invention whereas FIGS. 4 and 5 are examples useful for understanding the invention.
FIG. 6 is a diagrammatic three-dimensional view of a region of an example memory array.
FIG. 7 is another diagrammatic three-dimensional view of a region of the example memory array of FIG. 6.
FIG. 8 is a diagrammatic top view of another example device.
FIG. 9 is a diagrammatic top view of an example assembly at an example process stage.
FIGS. 10-23 are diagrammatic cross-sectional side views of a region of an example assembly at example process stages.
FIGS. 10A-23A are diagrammatic top-down sectional views of the regions of the example assembly at the example process stages of FIGS. 10-23. The views of FIGS. 10-23 are along the lines X-X of FIGS. 10A-23A, and the views of FIGS. 10A-23A are along the lines Z-Z of FIGS. 10-23.
FIG. 13B is a diagrammatic top-down sectional view of the example assembly of FIG. 13A at an example process stage subsequent to that of FIG. 13A.
FIGS. 16B and 16C are diagrammatic cross-sectional views of example structures that may be within regions labeled 16A and 16B in the top-down view FIG. 16A.
FIG. 22B is a diagrammatic cross-sectional view of an example structure that may be within a region labeled 22B in the top-down view FIG. 22A.

### DETAILED DESCRIPTION OF THE ILLUSTRATED EMBODIMENTS

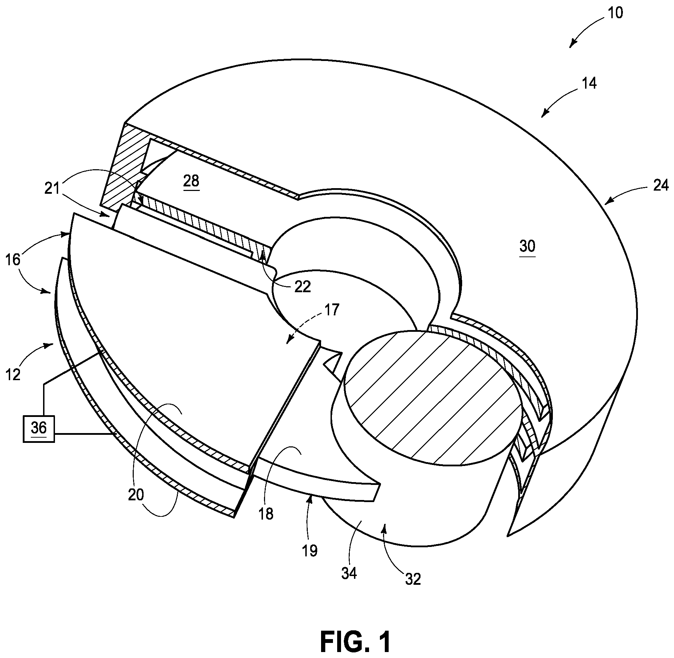

Some embodiments include integrated devices having capacitors and transistors, with the capacitors being horizontally offset from the transistors. The integrated devices are vertically stacked one atop another in an integrated assembly. In some embodiments, the integrated devices may be memory cells of a DRAM array. Example embodiments and examples useful for understanding the invention are described with reference to FIGS. 1-23.

Referring to FIG. 1, a device 10 is illustrated to comprise a transistor 12 and a capacitor 14.

The transistor 12 includes a gate 16, and a semiconductor material 18 adjacent the gate. The semiconductor material 18 includes a channel region 17. The channel region 17 is not visible in FIG. 1, as it is under a portion of the gate 16; but an approximate location of the channel region is diagrammatically illustrated with a dashed arrow. The semiconductor material 18 also includes a first source/drain region 19 on one side of the channel region 17, and a second source/drain region 21 on an opposing side of the channel region from the first source/drain region 19.

The transistor gate 16 comprises conductive material 20. Such conductive material may comprise any suitable electrically conductive composition(s), such as, for example, one or more of various metals (e.g., titanium, tungsten, cobalt, nickel, platinum, ruthenium, etc.), metal-containing compositions (e.g., metal silicide, metal nitride, metal carbide, etc.), and/or conductively-doped semiconductor materials (e.g., conductively-doped silicon, conductively-doped germanium, etc.).

The semiconductor material 18 may comprise any suitable composition or combination of compositions; such as, for example, one or more of silicon, germanium, III/V materials (e.g., gallium phosphide), semiconductor oxides, etc. The source/drain regions 19 and 21 may comprise conductively-doped regions. The channel region 17 may be doped to an appropriate level to achieve a desired threshold voltage.

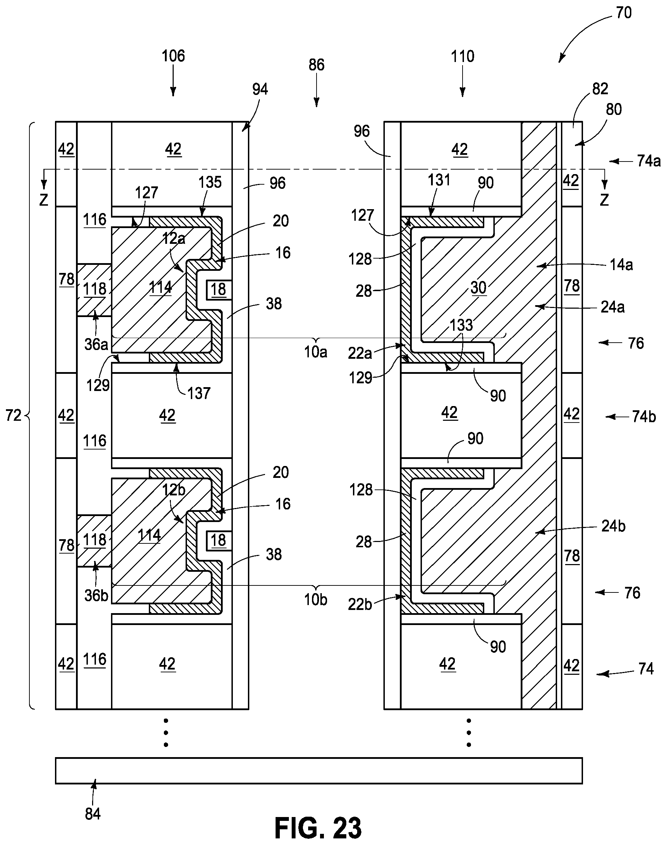

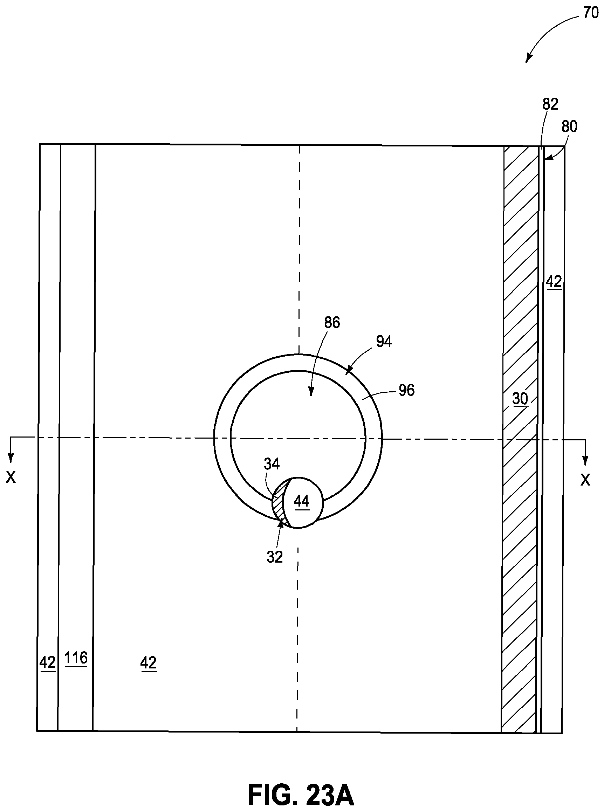

The capacitor 14 comprises a first electrode 22 and a second electrode 24. The electrodes 22 and 24 are spaced from one another, and dielectric material would be between the first and second electrodes. The dielectric material is not shown in FIG. 1 in order to simplify the drawing, but would be similar to the dielectric material 128 described below with reference to FIG. 23.

The electrodes 22 and 24 comprise conductive materials 28 and 30, respectively. Such conductive materials may comprise any suitable electrically conductive composition(s), such as, for example, one or more of various metals (e.g., titanium, tungsten, cobalt, nickel, platinum, ruthenium, etc.), metal-containing compositions (e.g., metal silicide, metal nitride, metal carbide, etc.), and/or conductively-doped semiconductor materials (e.g., conductively-doped silicon, conductively-doped germanium, etc.). The conductive materials 28 and 30 may be the same as one another in some embodiments, and may be different from one another in other embodiments.

In some embodiments, the electrodes 22 and 24 may be respectively referred to as a bottom electrode and a top electrode, a storage node electrode and a plate electrode, a bottom plate and a top plate, etc.

The second source/drain region 21 is coupled with the first electrode 22 of the capacitor 14; and in the illustrated embodiment is directly against the first electrode 22.

A bitline 32 extends through the device 10, and is coupled with the first source/drain region 19. In the illustrated embodiment, the first source/drain region 19 is directly against the bitline 32.

The bitline 32 comprises conductive material 34. The conductive material 34 may comprise any suitable electrically conductive composition(s), such as, for example, one or more of various metals (e.g., titanium, tungsten, cobalt, nickel, platinum, ruthenium, etc.), metal-containing compositions (e.g., metal silicide, metal nitride, metal carbide, etc.), and/or conductively-doped semiconductor materials (e.g., conductively-doped silicon, conductively-doped germanium, etc.).

A wordline 36 is coupled with the gate 16. In some embodiments, the device 10 may correspond to a memory cell, and may be one of many memory cells of a memory array (for instance, a DRAM array). The memory cell 10 may be addressed (i.e., read from/written to) utilizing the wordline 36 and the bitline 32.

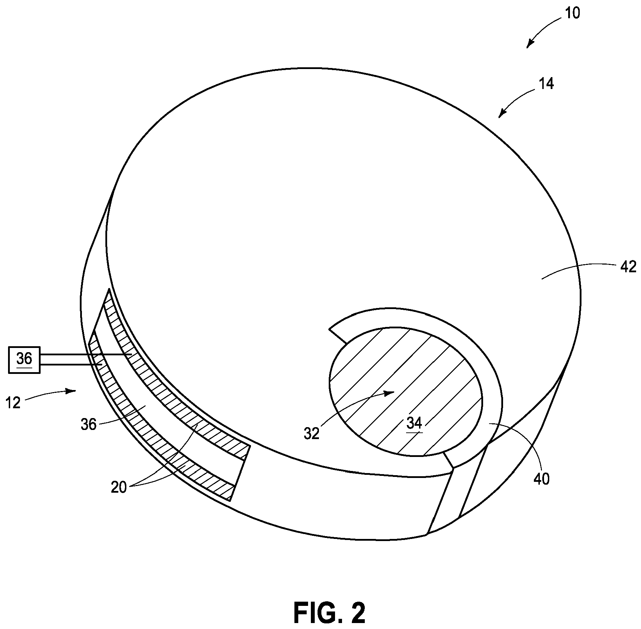

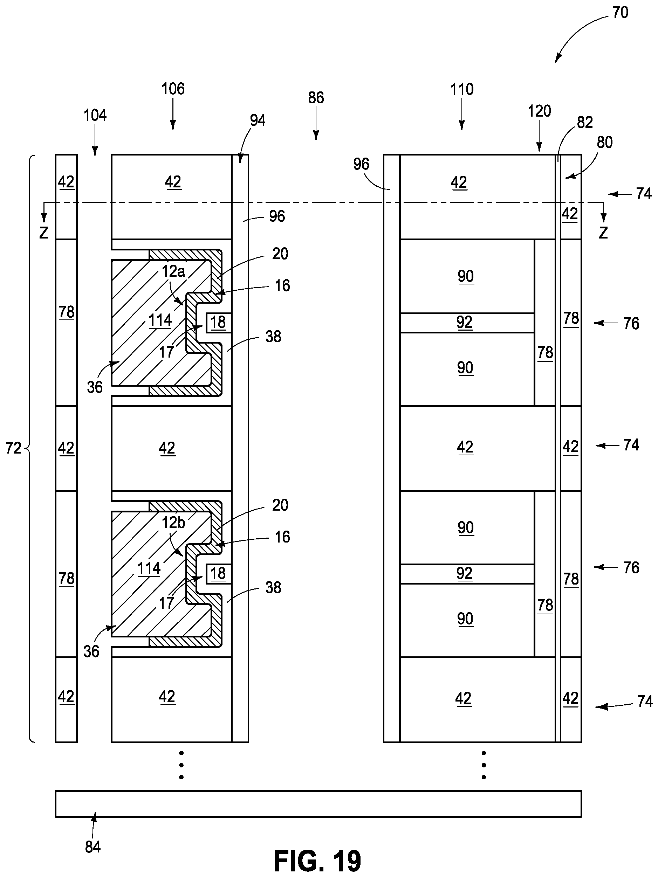

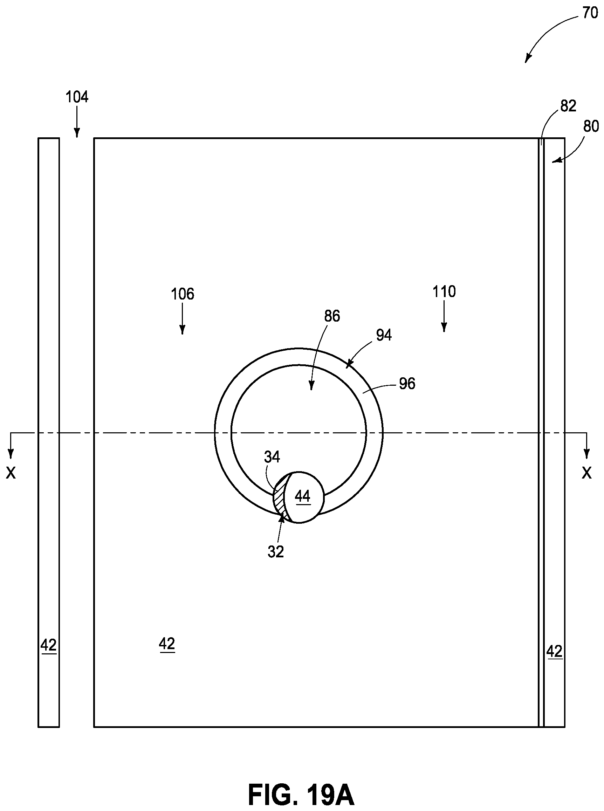

The device 10 may comprise numerous insulative materials which are not shown in the diagram of FIG. 1 in order to simplify the drawing. For instance, the capacitor dielectric material (i.e., the material 128 shown in FIG. 23) has already been mentioned. Also, gate dielectric material would be provided between the gate and the channel region 17 (example gate dielectric material is shown in FIG. 19 as material 38). Further, insulative materials would be provided to surround the device 10, and to isolate the bitline 32 from the capacitor 14. For instance, FIG. 2 shows insulative material 40 provided between the bitline 32 and the capacitor 14, and shows insulative material 42 over the transistor 12 and the capacitor 14.

The insulative materials 40 and 42 may comprise any suitable composition(s); and in some embodiments may comprise one or more of silicon dioxide, silicon nitride, high-k oxides (with high-k meaning a dielectric constant greater than that of silicon dioxide), etc. The insulative materials 40 and 42 may be the same composition as one another in some embodiments, and may be different compositions relative to one another in other embodiments. Further, in some embodiments either or both of the materials 40 and 42 may comprise two or more different materials, rather than the single homogeneous materials illustrated in FIG. 2.

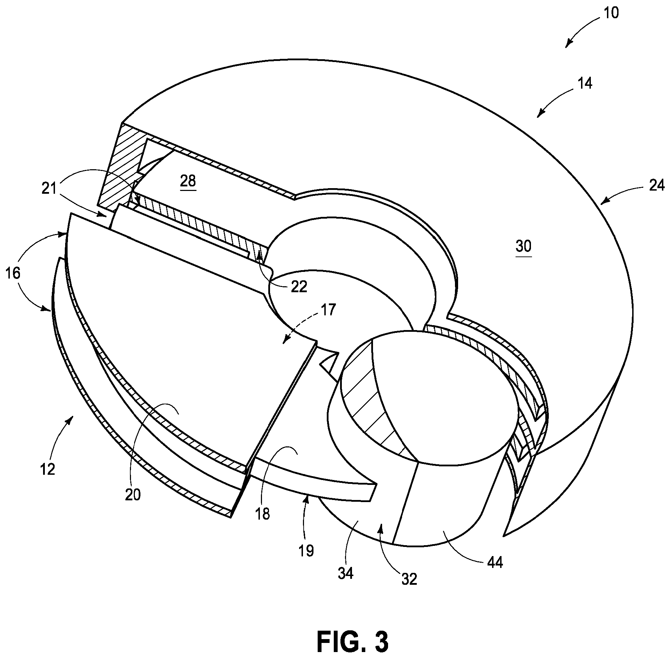

In some embodiments, the bitline 32 may have a different configuration than shown in FIG. 1. Specifically, FIG. 1 shows the bitline 32 configured to be substantially circular along a horizontal cross-section through the bitline. In other embodiments, the bitline may be polygonal, square, rectangular, elliptical, etc. FIG. 3 shows a configuration in which the bitline 32 is crescent-shaped along a horizontal cross-section through the bitline. The crescent-shaped bitline is along an insulative material 44. Such insulative material may comprise, for example, any of the compositions discussed above with reference to FIG. 2 for the insulative materials 40 and 42. In some embodiments, the insulative material 44 may be the same as one or both of the insulative materials 40 and 42.

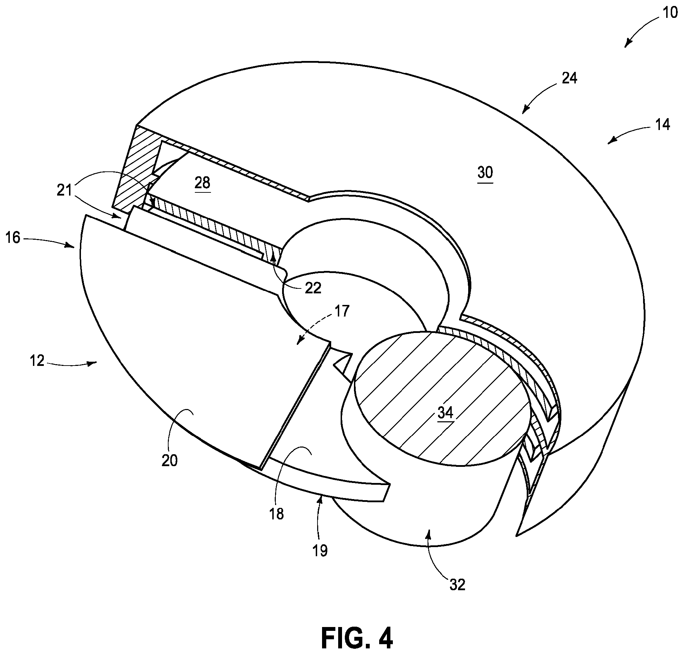

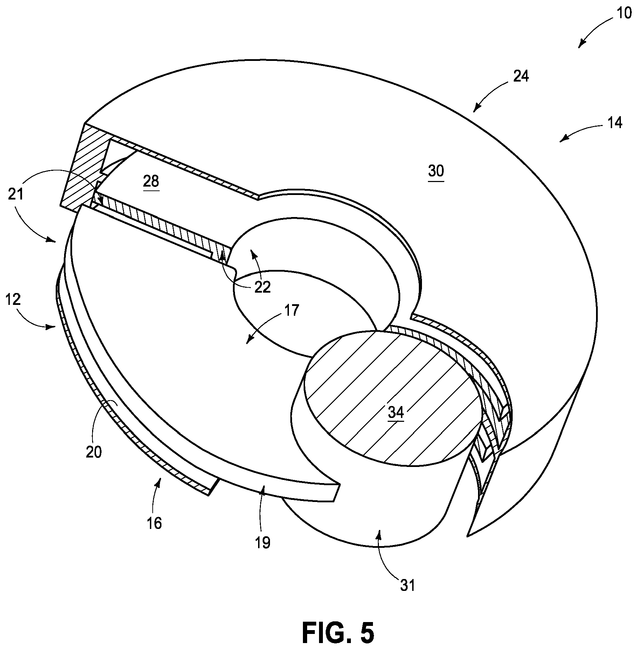

The gate 16 of FIGS. 1 and 3 is illustrated to be in a configuration which brackets the channel region 17 within semiconductor material 18. In other examples useful for understanding the invention, the gate 16 may have a different configuration. For instance, FIG. 4 shows a configuration in which the gate 16 is primarily over the channel region 17, and FIG. 5 shows a configuration in which the gate 16 is primarily under the channel region 17. Accordingly, FIGS. 4 and 5 show configurations in which the gate 16 is along one side of the channel region 17, rather than being along two opposing sides of the channel region (i.e., rather than bracketing the channel region).

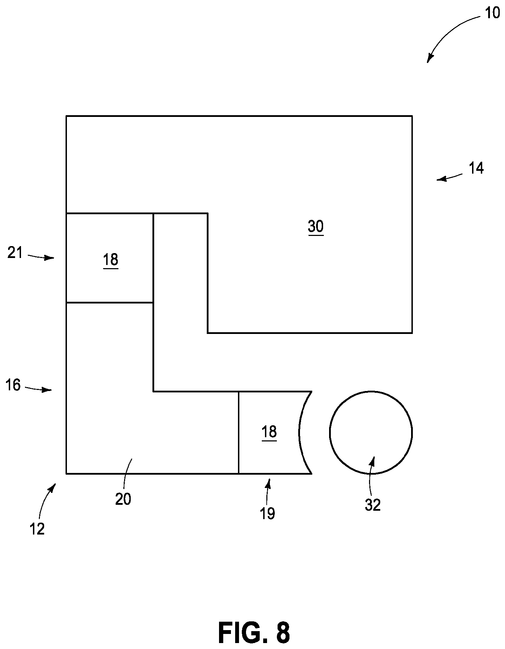

The devices 10 of FIGS. 1-5 have the capacitor 14 horizontally-offset relative to the transistor 12. Also, all of the devices are substantially circular along horizontal cross-sections through the devices (with the term "substantially circular" meaning circular to within reasonable tolerances of fabrication and measurement). The devices may have other shapes in other embodiments, as discussed in more detail below with reference to FIG. 8.

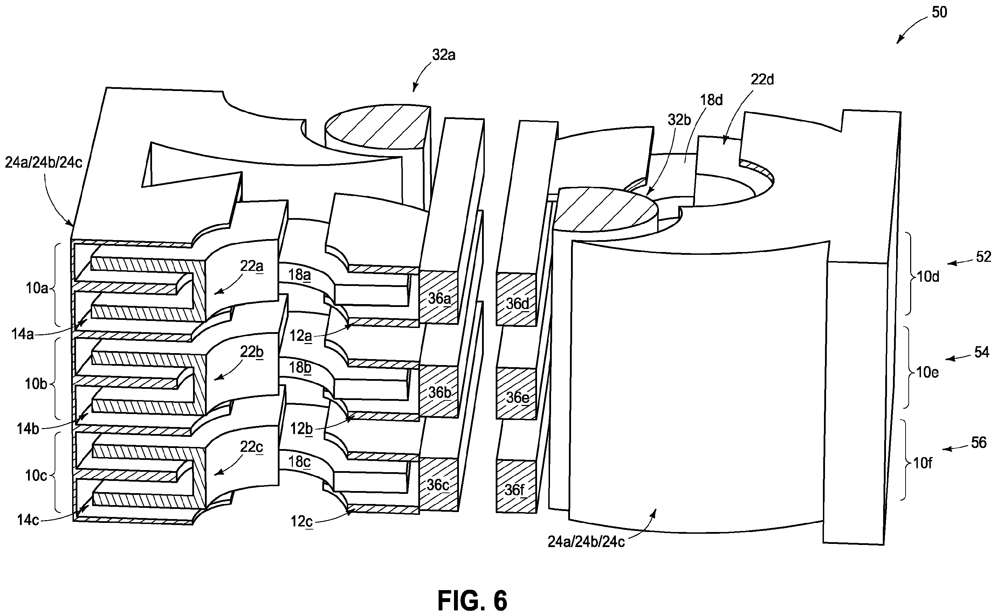

The devices 10 of FIGS. 1-5 may be utilized as memory cells within memory arrays. For instance, FIG. 6, shows an example memory array 50 comprising memory cells 10a-f having the configuration of the device 10 of FIG. 1. Each memory cell comprises a capacitor (e.g., the capacitors 14a-c visible in FIG. 6) coupled with an associated transistor (e.g., the transistors 12a-12c visible in FIG. 6). The capacitors are vertically-stacked one atop another along levels 52, 54 and 56. The level 52 comprises the memory cells 10a and 10d; the level 54 comprises the memory cells 10b and 10e; and the level 56 comprises the memory cells 10c and 10f. Insulative materials are not shown in FIG. 6 in order to simplify the drawing, but it is to be understood that insulative materials analogous those described above with reference to FIGS. 1 and 2 (e.g., capacitor dielectric material, gate dielectric material, etc.) would be provided.

The capacitors comprise the first electrodes (for instance, the electrodes 22a, 22b and 22c) and the second electrodes (for instance, the electrodes 24a, 24b and 24c). In the illustrated embodiment, the second electrodes along each vertical stack are comprised by a single common plate. Accordingly, the electrodes 24a, 24b and 24c are within a common plate labeled 24a/24b/24c; and the electrodes 24d, 24e and 24f are within a common plate labeled 24d/24e/24f. The common plates 24a/24b/24c and 24d/24e/24f may be coupled with one another in some embodiments, and may be held at any suitable voltage (i.e., ground, Vcc/2, etc.).

Wordlines (e.g., access lines, etc.) 36a-f extend horizontally, and are coupled with transistor gates of the memory cells 10a-f (the transistor gates are not labeled in FIG. 6, but would be analogous to the transistor gate 16 of FIG. 1).

Digit lines (e.g. bitlines, sense lines, etc.) extend vertically and are coupled with source/drain regions of the memory cells 10a-f (the source/drain regions are not labeled in FIG. 6, but the digit lines would be coupled to source/drain regions analogous to the source/drain region 19 of FIG. 1).

Each memory cell 10a-f may be uniquely addressed through a combination of one of the digit lines (32a, 32b), and one of the wordlines (36a-f). In some embodiments, the wordlines may be considered to extend along rows of the array of memory cells, and the digit lines may be considered to extend along columns of the array of memory cells.

FIG. 6 shows a region of the memory array 50, and the memory array may comprise numerous other memory cells besides the illustrated six memory cells 10a-f. The memory array may extend vertically above and below the illustrated region, and may extend laterally to the left and right of the illustrated region, as well as into and out of the page relative to the illustrated region. The memory array may comprise any suitable number of memory cells; and in some embodiments may comprise hundreds, thousands, millions, billions, etc., of memory cells.

The memory cells within each level (e.g., the levels 52, 54 and 56) may be substantially identical to one another (with the term "substantially identical" meaning identical to within reasonable tolerances of fabrication and measurement). Further, at least some of the memory cells within one vertical level (e.g., level 52) may be substantially identical to memory cells within another vertical level (e.g., level 54). In some embodiments, all of the memory cells within one vertical level may be substantially identical to all of the memory cells within another vertical level. In some embodiments, all of the memory cells within all of the vertical levels may be substantially identical to one another.

In some embodiments, at least some of the memory cells within one vertical level may not be substantially identical to at least some of the memory cells within another vertical level. Such may enable different vertical levels to be tailored for different applications. Differences between the memory cells in one vertical level relative to the memory cells in another vertical level may provide different performance characteristics amongst transistors of the memory cells (such as, for example, differences in one or more of effective gate width, effective gate length, threshold voltage, on-current, off-current, etc.) and/or different performance characteristics amongst capacitors of the memory cells (such as, for example, differences in capacitance).

In some embodiments, differences in performance characteristics amongst transistors of the memory cells may be achieved by providing different semiconductor material within one level as compared to another level (e.g., the semiconductor material 18a may be different relative to the semiconductor material 18b); with the differences between the semiconductor materials being differences in composition, differences in thickness, and/or differences in any other suitable physical characteristics. Alternatively, or additionally, differences in performance characteristics between one level and another may be achieved by providing different dopants and/or dopant concentrations within the semiconductor material of one level as compared to the semiconductor material of another level (e.g., by providing different dopant and/or dopant concentrations within the semiconductor material 18a as compared to the semiconductor material 18b). Differences in performance characteristics amongst capacitors of different levels may be achieved by, for example, forming the electrodes to be of different shapes amongst the capacitors, utilizing different materials for capacitor dielectric amongst the capacitors and/or by utilizing different thicknesses of capacitor dielectric amongst the capacitors.

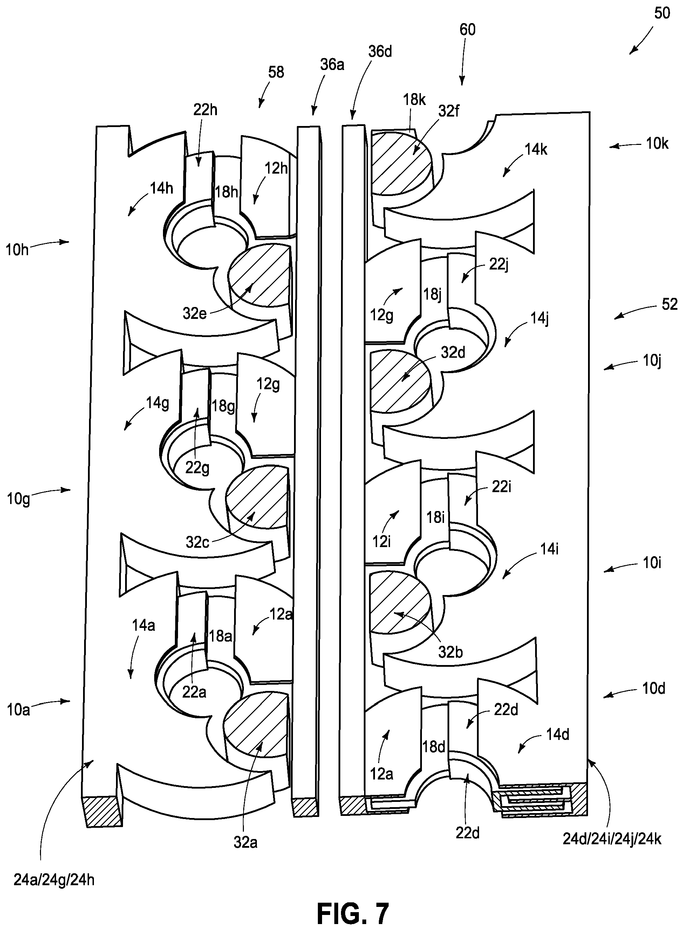

FIG. 7 shows another view of a region of the memory array 50, and shows a pair of adjacent rows 58 and 60 along the level 52. Insulative materials are not shown in FIG. 7 in order to simplify the drawing, but it is to be understood that insulative materials analogous those described above with reference to FIGS. 1 and 2 (e.g., capacitor dielectric material, gate dielectric material, etc.) would be provided.

The row 58 comprises memory cells 10a, 10g and 10h; and the row 60 comprises memory cells 10d, 10i, 10j and 10k. The embodiment of FIG. 7 illustrates one example arrangement of digit lines (32a-f), and wordlines (36a and 36d) relative to the memory cells. Other arrangements may be utilized in other embodiments.

Although the memory cells (i.e., devices) of FIGS. 1-7 are illustrated to be substantially circular along horizontal cross-sections through the memory cells, it is to be understood that in other embodiments the memory cells may have other configurations. For instance, FIG. 8 shows a top view of a memory cell 10 in a configuration in which the memory cell has a polygonal shape along a horizontal cross-section through the memory cell. In the illustrated embodiment, the memory cell is substantially square along the horizontal cross-section through the memory cell. In other embodiments, the memory cell may have any other suitable shape.

Insulative materials are not shown in FIG. 8 in order to simplify the drawing, but it is to be understood that insulative materials analogous those described above with reference to FIGS. 1 and 2 (e.g., capacitor dielectric material, gate dielectric material, etc.) would be provided.

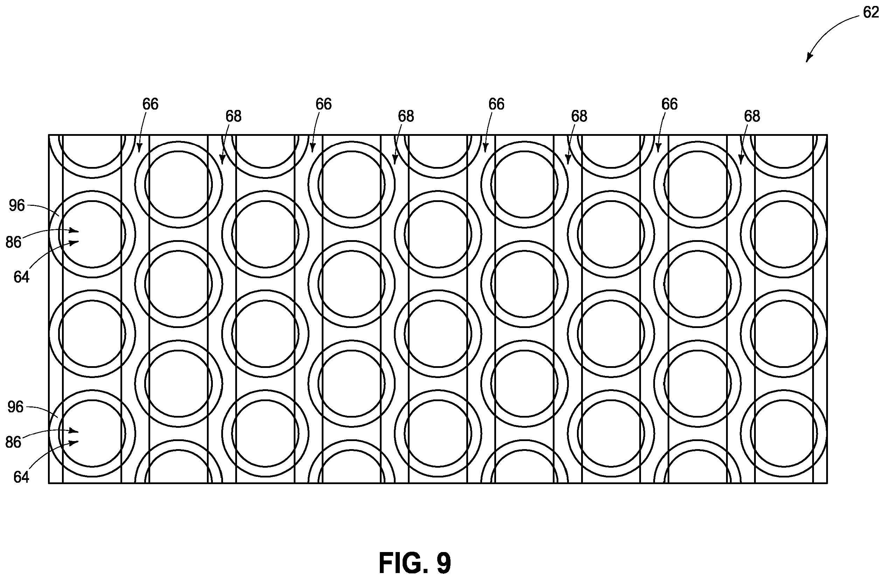

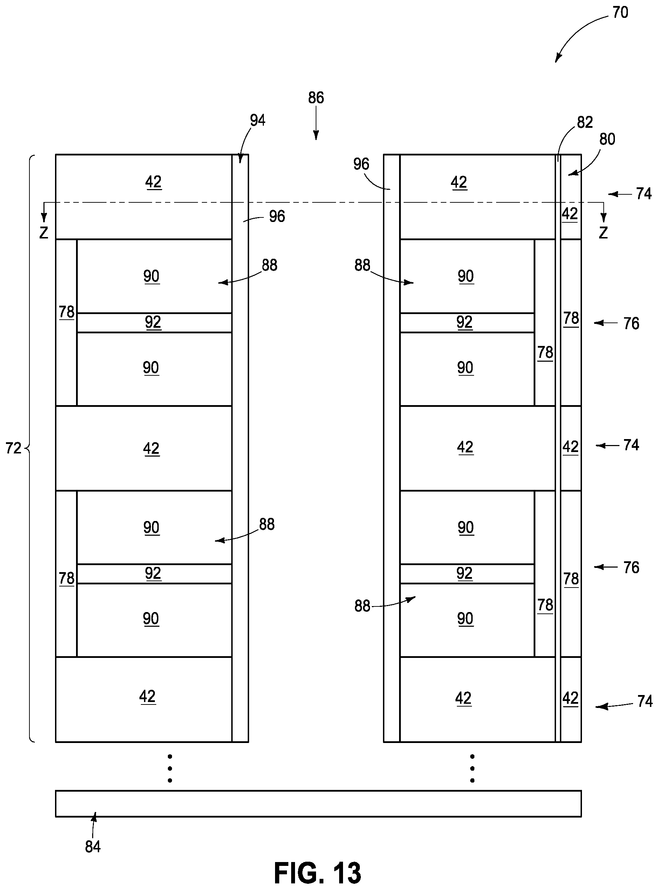

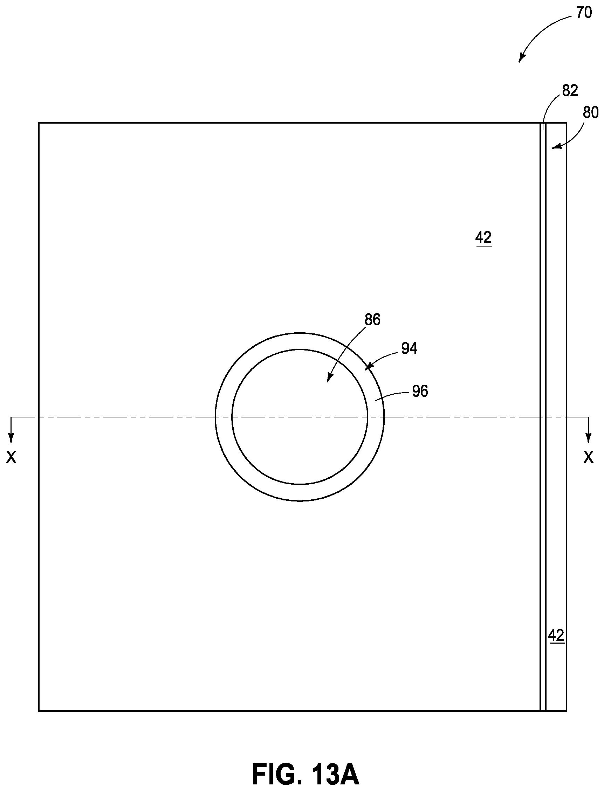

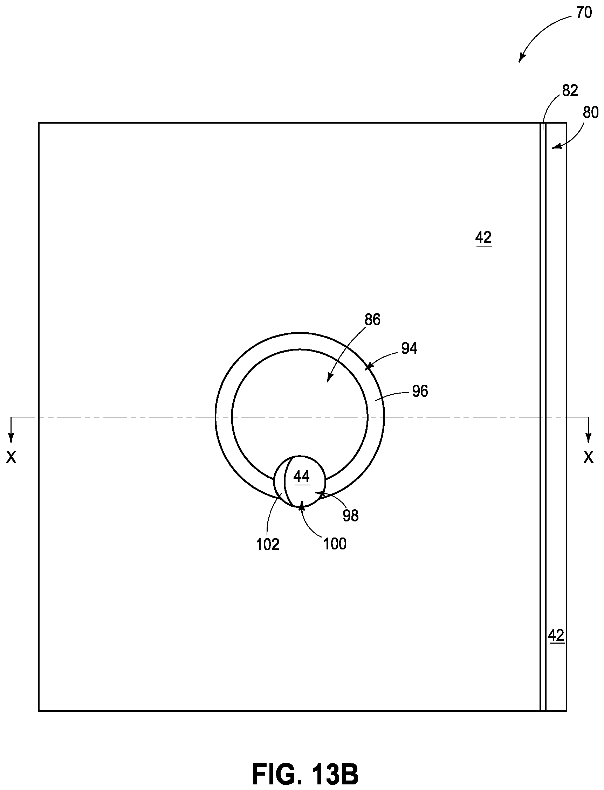

The devices 10 of FIGS. 1-8 may be fabricated with any suitable processing. In some embodiments, the devices are fabricated by providing holes through a stack of materials. The transistors are formed along a side of the holes, and the capacitors are formed along other sides of the holes. FIG. 9 shows a top view of a construction 62 illustrating example locations 64 for holes 86 (only some which are labeled) utilized during fabrication devices. The holes 86 are lined with a material 96, which is described in more detail below with reference to FIG. 13. FIG. 9 also shows locations 66 where slits will be formed for fabrication of the transistor gates and wordlines, and shows locations 68 where slits will be formed for fabrication of the capacitors. The construction 62 of FIG. 9 is provided to provide the reader with an overview of an example method for fabricating an array of devices (e.g., the example devices 10 of FIGS. 1-8) in accordance with an example embodiment. In other embodiments, the devices may be fabricated utilizing other constructions.

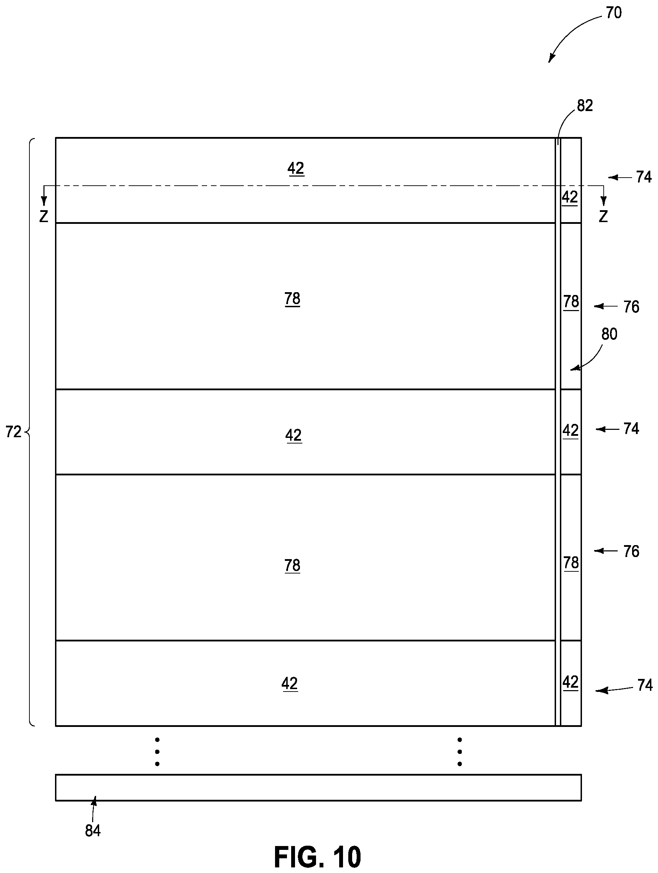

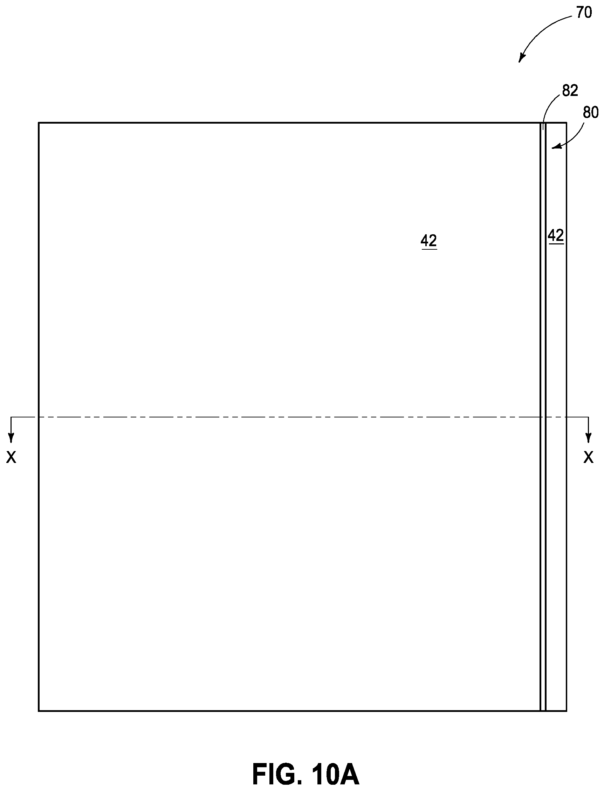

An example method for fabricating devices analogous to the device 10 of FIG. 3 is described with reference to FIGS. 10-23 and 10A-23A. The views of FIGS. 10A-23A are along the cross-sections Z-Z of FIGS. 10-23, respectively; and the views of FIGS. 10-23 are along the lines X-X of FIGS. 10A-23A, respectively. It is to be understood that the example method of FIGS. 10-23 and 10A-23A. may be modified to fabricate any of the devices of FIGS. 1-8, or analogous devices.

Referring to FIGS. 10 and 10A, an assembly 70 comprises a stack 72 of first levels 74 and second levels 76. The levels 74 and 76 alternate with one another along a vertical direction.

The first levels 74 may comprise insulative material 42, and may be referred to as insulative levels. The insulative material 42 may comprise any suitable composition(s); and in some embodiments may comprise, consist essentially of, or consist of silicon nitride. The insulative material 42 of first levels 74 may be the same as that described above with reference to FIG. 2.

The second levels 76 comprise sacrificial material 78. The sacrificial material 78 is a material selectively removable relative to the insulative material 42. In some embodiments, the sacrificial material 78 may comprise, consist essentially of, or consist of silicon dioxide. For instance, the sacrificial material 78 may comprise silicon dioxide which is effectively not doped with boron, phosphorus, or other dopants. Such sacrificial material may be referred to as a non-doped silicate glass (NSG). It may be difficult to have absolutely no dopant within silicate glass, and thus the NSG is referred to as being "effectively not doped". In some embodiments, the dopant level of the NSG may be less than or equal to about 10¹⁵ atoms/cm³.

The second levels 76 may be referred to as device levels, since integrated devices are eventually formed within the second levels 76.

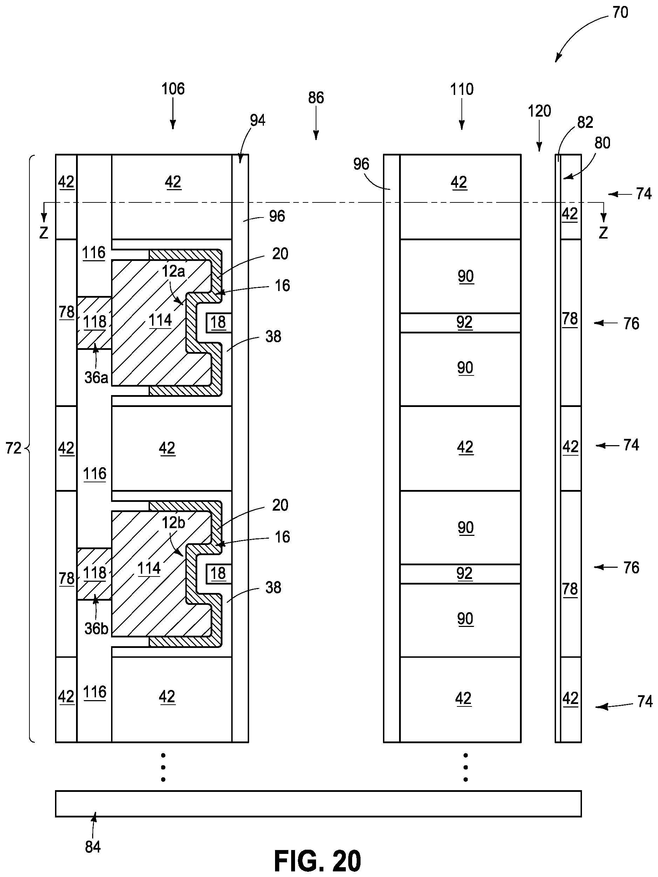

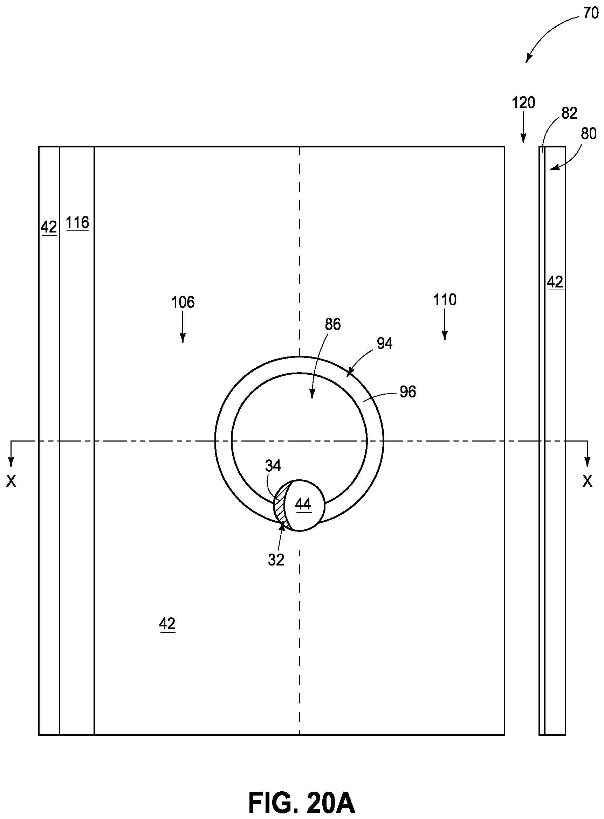

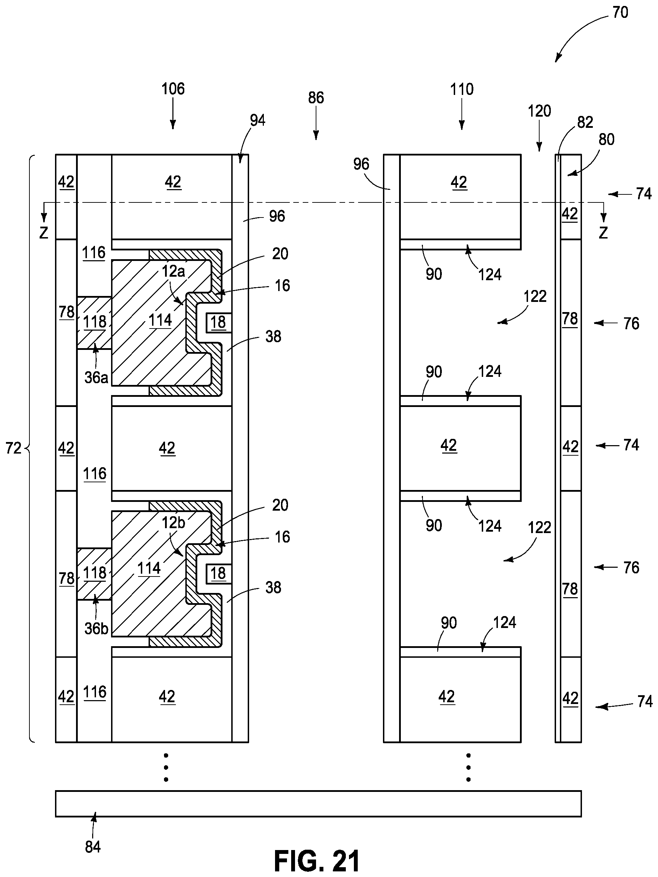

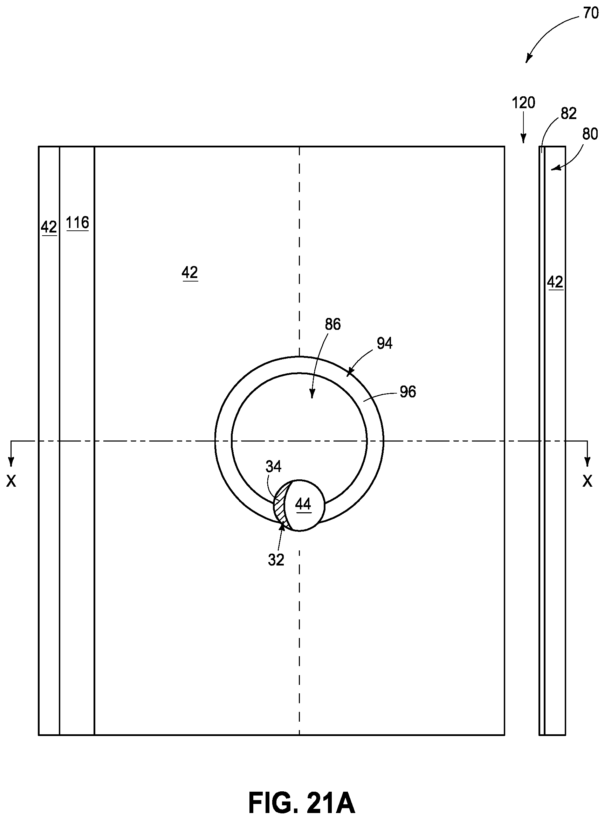

An insulative panel 80 extends through the stack 72. The insulative panel 80 comprises an insulative material 82. The material 82 may comprise any suitable composition or combination of compositions; and in some embodiments may comprise a same composition as the insulative material 42. For instance, the materials 82 and 42 may both comprise, consist essentially of, or consist of silicon nitride in some embodiments. The panel 80 may be utilized to define edges of capacitors at processing stages described below with reference to FIGS. 20 and 21. In some embodiments, such edges may be defined without utilization of the panel 80; and accordingly the panel 80 may be omitted.

The stack 72 is supported by a base 84. The base 84 may comprise semiconductor material; and may, for example, comprise, consist essentially of, or consist of monocrystalline silicon. The base 84 may be referred to as a semiconductor substrate. The term "semiconductor substrate" means any construction comprising semiconductive material, including, but not limited to, bulk semiconductive materials such as a semiconductive wafer (either alone or in assemblies comprising other materials), and semiconductive material layers (either alone or in assemblies comprising other materials). The term "substrate" refers to any supporting structure, including, but not limited to, the semiconductor substrates described above. In some applications, the base 84 may correspond to a semiconductor substrate containing one or more materials associated with integrated circuit fabrication. Such materials may include, for example, one or more of refractory metal materials, barrier materials, diffusion materials, insulator materials, etc.

A gap is provided between the stack 72 and the base 84 to indicate that there may be other materials, components, etc., provided between the stack 22 and the base 84 in some embodiments. Alternatively, the stack 72 may be provided directly against an upper surface of the base 84.

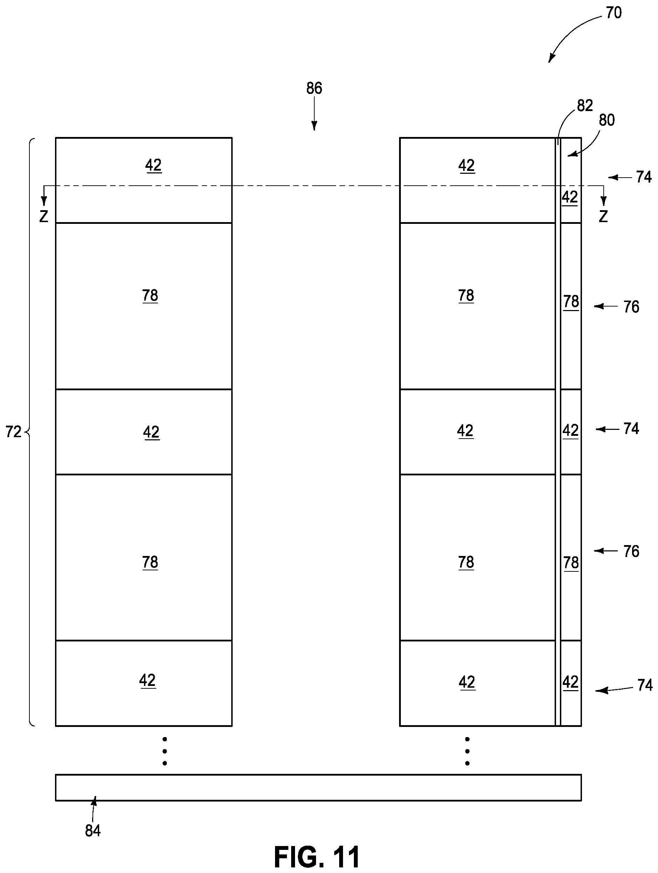

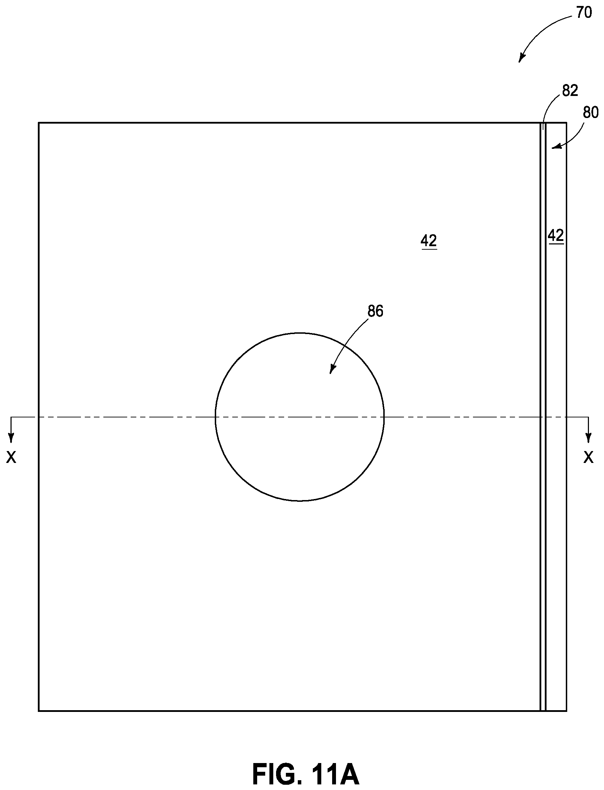

Referring to FIGS. 11 and 11A, an opening 86 is formed through the stack 72. The opening 86 may be referred to as a first opening, and may be representative of a plurality of openings formed through the stack 74 (a plurality of openings 86 is shown in FIG. 9, and discussed above). Only a single opening 86 is shown in the views of FIGS. 11 and 11A in order to simplify the drawings, but it is to be understood that such opening may be one of a large number of substantially identical openings formed through the stack.

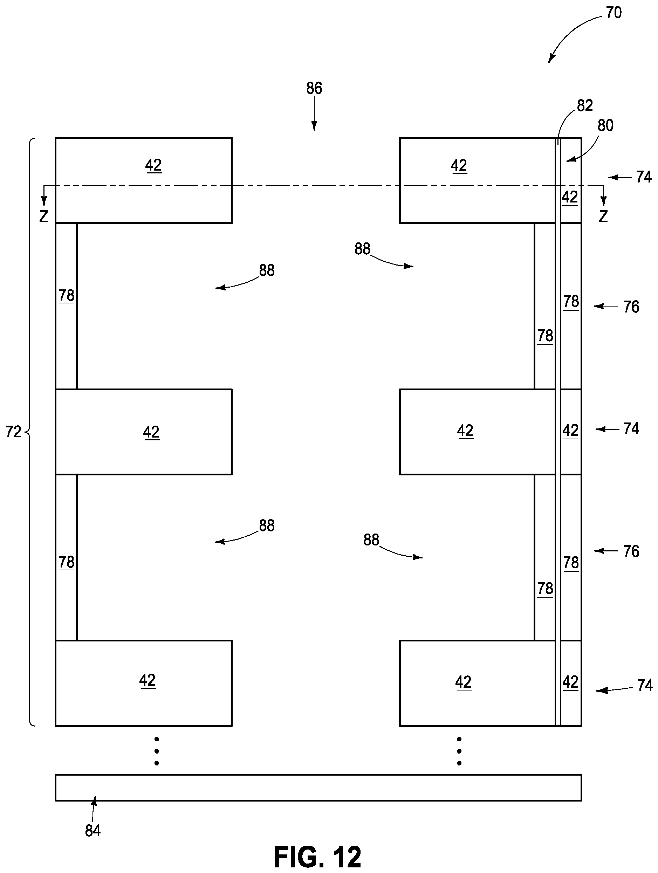

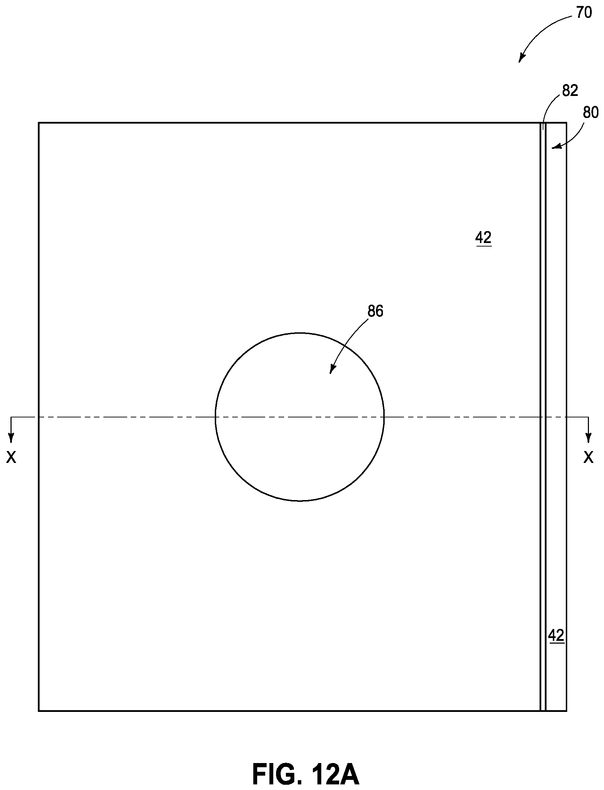

Referring to FIGS. 12 and 12A, the sacrificial material 78 is recessed relative to the insulative material 42 to form cavities 88.

Referring to FIGS. 13 and 13A, sacrificial materials 90 and 92 are formed within the cavities 88, and then an insulative liner 94 is formed along a peripheral boundary of the opening 86. In the illustrated embodiment, a layer of the first material 92 is provided between a pair of layers of the second material 90 within each of the cavities 88.

The sacrificial materials 90 and 92 may comprise any suitable compositions or combinations of compositions. It can be desired that the second sacrificial material 92 be selectively removable relative to the first sacrificial material 90. In some embodiments, the sacrificial material 90 may comprise, consist essentially of, or consist of NSG, and may be the same as the sacrificial material 78. The sacrificial material 92 may comprise a doped silicate glass; and in some embodiments may comprise, consist essentially of, or consist of phosphosilicate glass. The doped silicate glass comprises a higher concentration of dopant (e.g., phosphorus) than the NSG, and in some embodiments may comprise a dopant concentration of at least about 10¹⁶ atoms/cm³.

The liner 94 comprises an insulative material 96. The material 96 may comprise any suitable composition or combination of compositions; and in some embodiments may comprise, consist essentially of, or consist of silicon nitride.

Referring to FIG. 13B, construction 70 is shown at a processing stage subsequent to that of FIG. 13A. A second opening 98 is formed overlapping a region of the first opening 86, and the second opening 98 is filled with a digit line template 100. The digit line template 100 extends vertically through the stack 72. In the illustrated embodiment, the digit line template comprises two materials 44 and 102. The material 44 may comprise any of the insulative compositions described above with reference to FIG. 3. The material 102 is a sacrificial material, and in some embodiments may comprise, consist essentially of, or consist of phosphosilicate glass. The illustrated digit line template 100 comprising the two materials 44 and 102 will ultimately form a digit line 32 having the configuration shown in FIG. 3 as being crescent-shaped along a horizontal cross-section. In other embodiments, the digit line template 100 may comprise only the sacrificial material 102, and may be utilized to form a digit line 32 having the configuration shown in FIG. 1 as being circular shaped along a horizontal cross-section. Alternatively, the sacrificial material 102 may be in any other suitable shape for forming a desired digit line configuration.

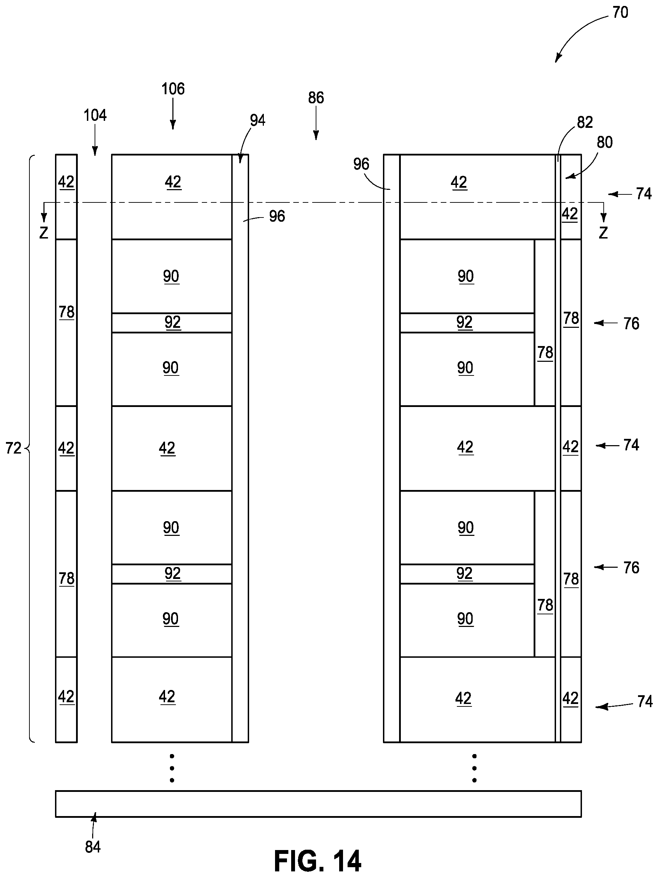

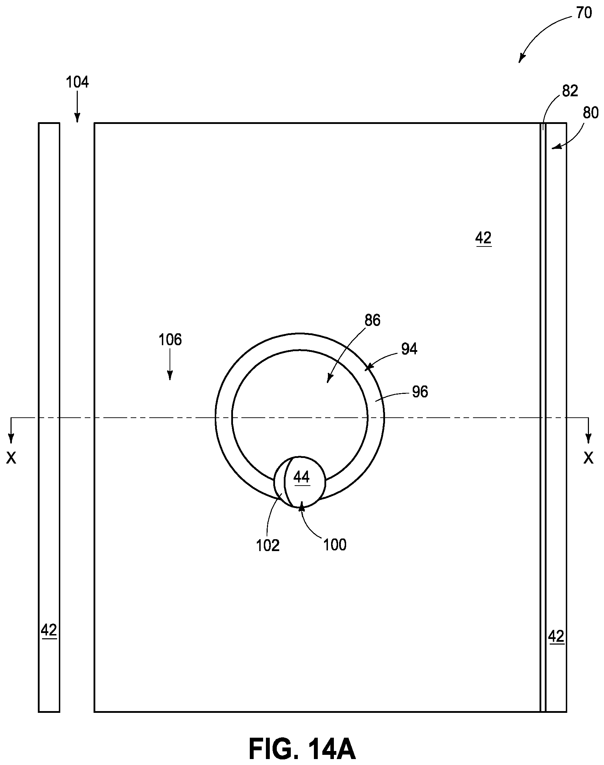

Referring to FIGS. 14 and 14A, a slit 104 is formed along a first side 106 of the opening 86. The slit 104 penetrates through the materials 42, 90 and 92.

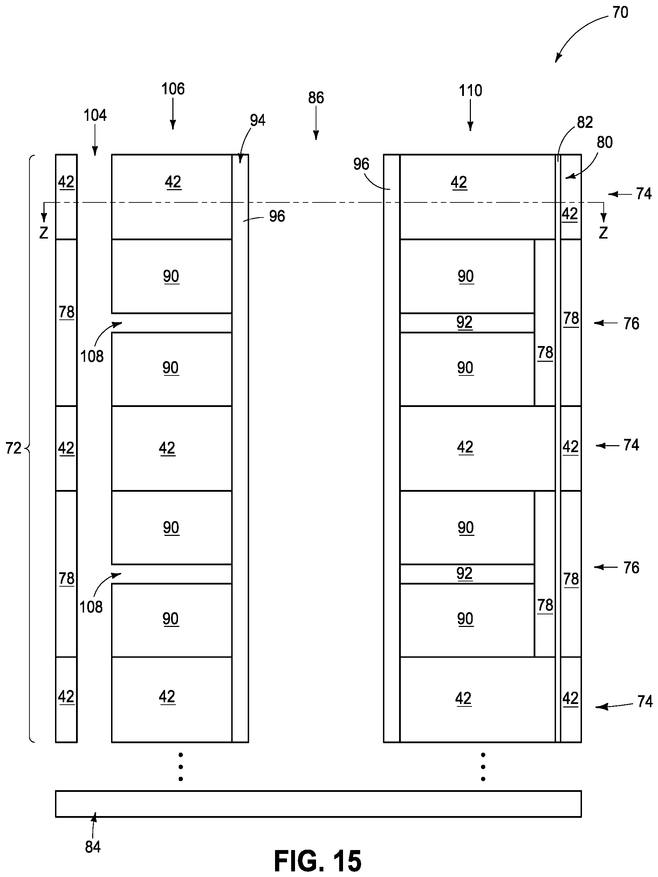

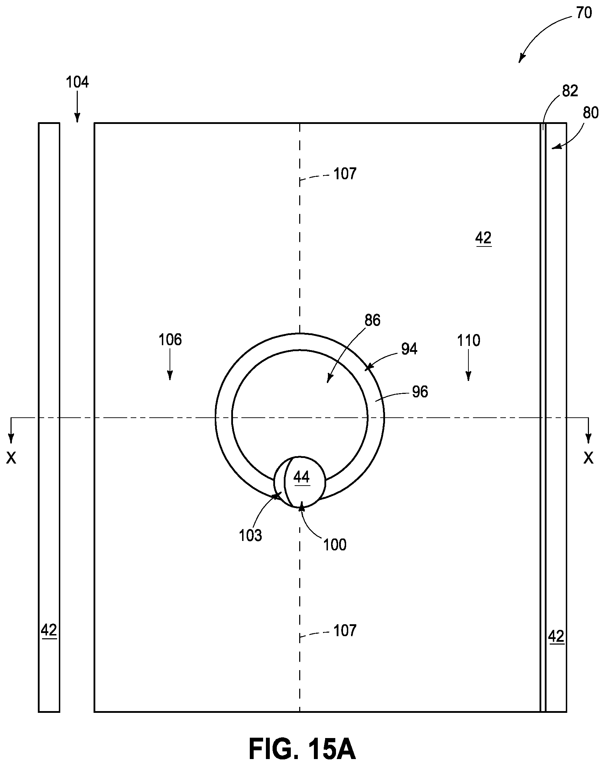

Referring to FIGS. 15 and 15A, the sacrificial material 92 is removed from along the slit 104 to form horizontally-extending voids 108. Such removal may be accomplished by passing appropriate etchant into the slit 104, and utilizing a timed etch to remove a desired amount of the sacrificial material 92. The voids 108 may be formed to extend about halfway around opening 86. Such is diagrammatically illustrated in the top view of FIG. 15A utilizing a dashed line 107 to illustrate approximate lateral boundaries (i.e., edges) of the voids 108 within the stack 72. The voids 108 will be along the left side (the first side 106) of the opening 86, and remaining portions of the sacrificial material 92 will be along the right side of the opening 86. Such right side of the opening may be referred to as a second side 110.

In some embodiments, the sacrificial material 102 of the digit line template 100 may comprise a same composition as the sacrificial material 92 (e.g., both may comprise phosphosilicate glass). Accordingly, the sacrificial material 102 of the digit line template 100 may be removed simultaneously with the removal of the sacrificial material 92 to leave a void 103.

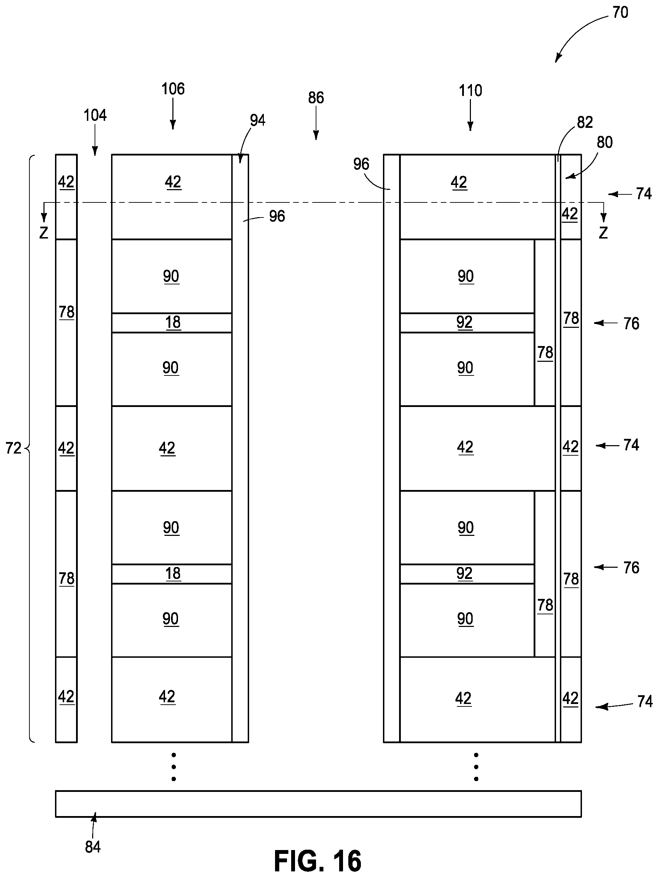

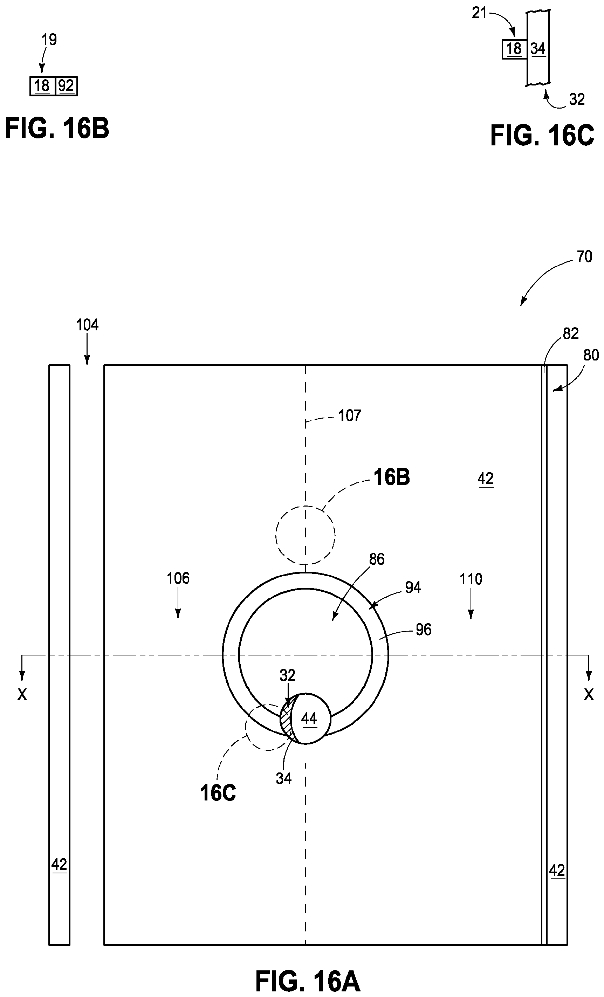

Referring to FIGS. 16 and 16A, semiconductor material 18 is provided within the horizontally-extending voids 108 (FIG. 15), and such semiconductor material replaces the sacrificial material 92 which had been removed to form such voids. The semiconductor material 18 may abut the sacrificial material 92 along the edges of the previous voids 108 (with such edges being diagrammatically illustrated as being approximately along a location of the dashed line 107 of FIG. 16A). FIG. 16B shows a region along the edge within one of the levels 76 of stack 72, and shows the semiconductor material 18 directly against the sacrificial material 92.

The void 103 (FIG. 15A) may be filled with conductive material 34 to form the digit line 32. In some embodiments, the conductive material may comprise conductively-doped silicon and/or metal. A region of the semiconductor material 18 may be directly against the conductive material 34. FIG. 16C shows a region within one of the levels 76 of stack 72 where the semiconductor material 18 contacts the conductive material 34.

In some embodiments, construction 70 may be heated or otherwise operably processed to cause out-diffusion of phosphorus from phosphosilicate glass of sacrificial material 92 into the semiconductor material 18 to form the first source/drain region 19; and to cause out-diffusion from conductively-doped semiconductor material of the digit line 32 into the semiconductor material 18 to form the second source/drain region 21.

Although the semiconductor material 18 is shown to be the same in all of the vertically-stacked levels 76, in other embodiments the semiconductor material within one of the vertically-stacked levels 76 may be different than that within another of the vertically-stacked levels 76. Such may enable fabrication of vertically-stacked transistor devices having different performance characteristics relative to one another; with the vertically-stacked transistor devices being shown in FIG. 20 as devices 12a and 12b.

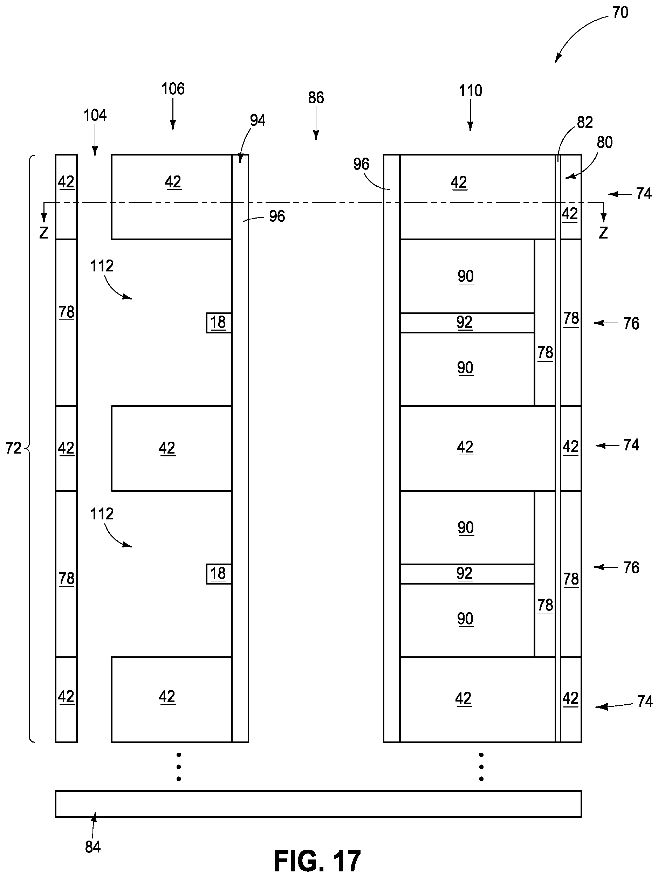

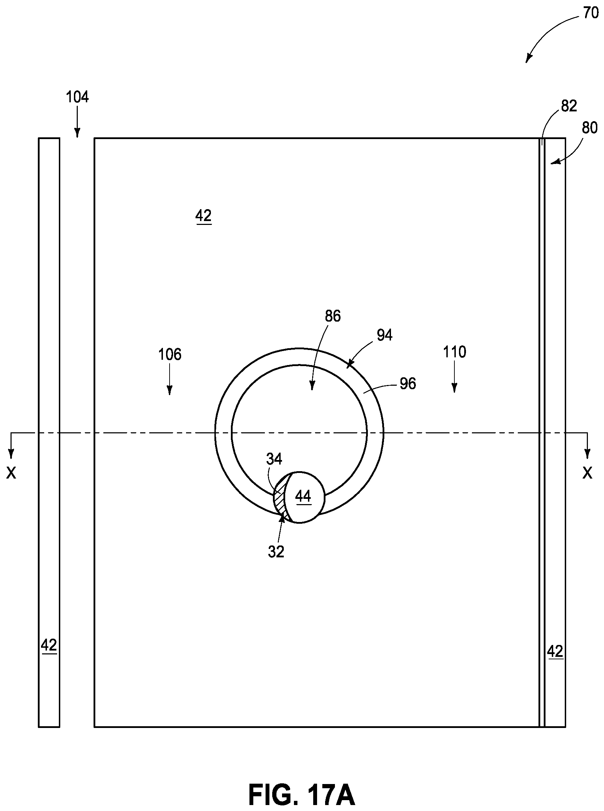

Referring to FIGS. 17 and 17A, the sacrificial material 90 is removed from along the first side 106 of the opening 86, together with a portion of the semiconductor material 18, to leave cavities 112. Such removal may be accomplished by flowing one or more suitable etchants into the slit 104.

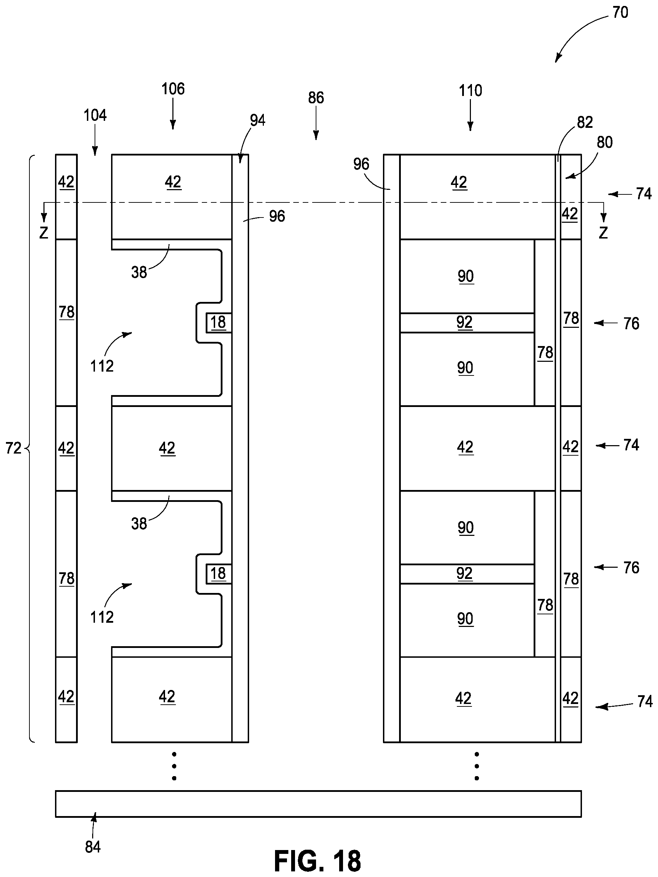

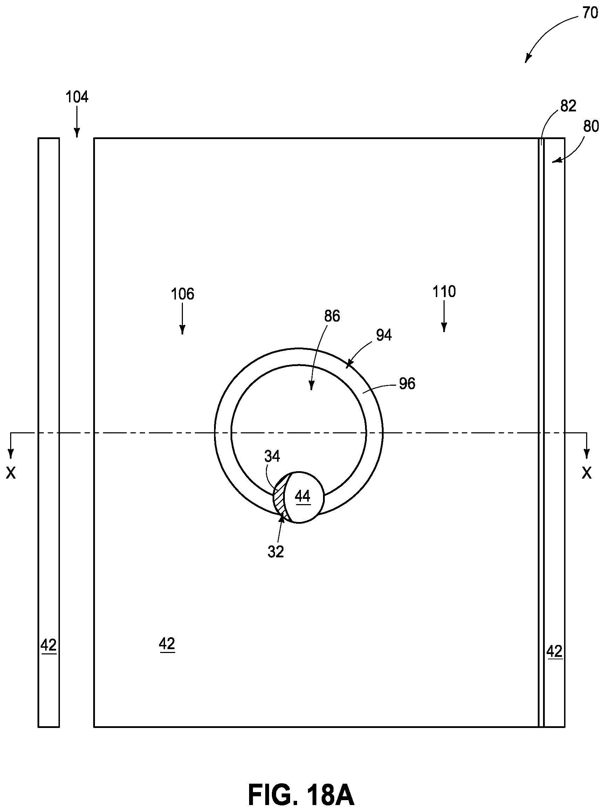

Referring to FIGS. 18 and 18A, gate dielectric material 38 is deposited within the voids 112. The gate dielectric material 38 may comprise any suitable composition(s); and in some embodiments may comprise, consist essentially of, or consist of silicon dioxide.

Referring to FIGS. 19 and 19A, gate material 20 and wordline material 114 are formed within the voids 112 (FIG. 18). The gate material 20 and wordline material 114 may comprise any suitable compositions, and may be the same as one another or different from one another. In some embodiments, the gate material 20 may comprise, consist essentially of, or consist of tungsten; and the wordline material 114 may comprise a conductive material to which the tungsten may be selectively etched. For instance, in some embodiments the wordline material 114 may comprise, consist essentially of, or consist of titanium nitride.

The gate material 20 forms transistor gates 16.

The gate dielectric material 38, semiconductor material 18 and gate material 20 together form transistor devices 12a and 12b along the first side 106 of the opening 86. The semiconductor material 18 comprises the channel regions 17 extending along the gates 16, and also comprises the source/drain regions 19 and 21 (shown in FIGS. 1 and 3, but not visible in FIGS. 19 and 19A).

Referring to FIGS. 20 and 20A, insulative material 116 and conductive material 118 are formed within the slit 104 (FIGS. 19 and 19A). The insulative material 116 may comprise any suitable composition or combination of compositions; and in some embodiments may comprise, consist essentially of, or consist of one or more of silicon dioxide, silicon nitride, etc. The insulative material 116 may be a same composition as the insulative material 42 in some embodiments.

The conductive material 118 may comprise any suitable composition(s), such as, for example, one or more of various metals (e.g., titanium, tungsten, cobalt, nickel, platinum, ruthenium, etc.), metal-containing compositions (e.g., metal silicide, metal nitride, metal carbide, etc.), and/or conductively-doped semiconductor materials (e.g., conductively-doped silicon, conductively-doped germanium, etc.). The conductive material 118 may form wordlines 36a and 36b extending in and out of the page relative to the cross-section of FIG. 20. In some embodiments, the conductive material 118 may be a same composition as the conductive material 114, and in other embodiments the conductive materials 118 and 114 may comprise different compositions relative to one another.

A slit 120 is formed along the second side 110 of the opening 86. The slit 120 extends through the first and second levels 74 and 76, and in the illustrated embodiment is formed along a side of the panel 80.

Referring to FIGS. 21 and 21A, materials 90 and 92 are removed from along the right side 110 of opening 86 to form voids 122. In the illustrated embodiment, the material 90 is thinned to leave liners 124 of the material 90 along upper and lower regions of the voids 122.

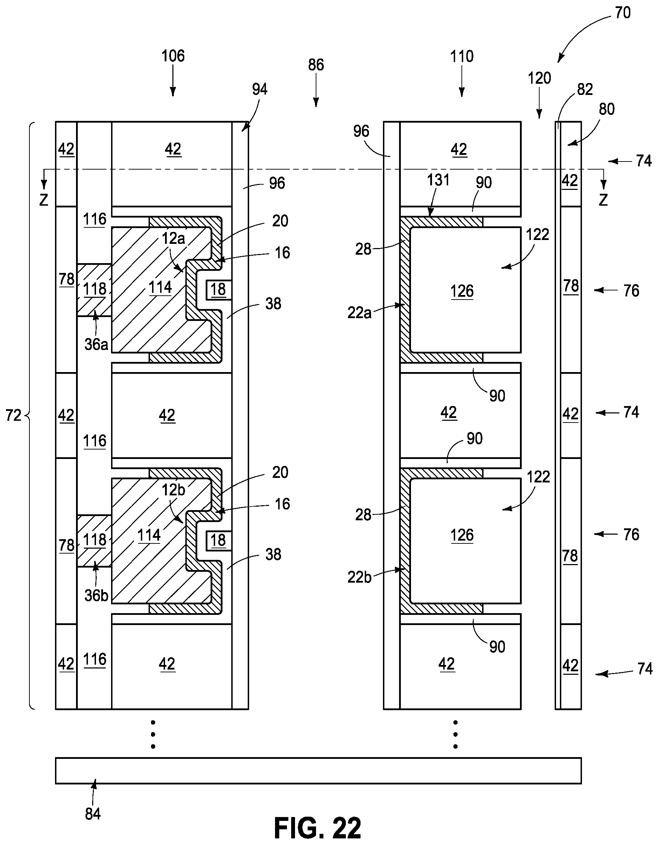

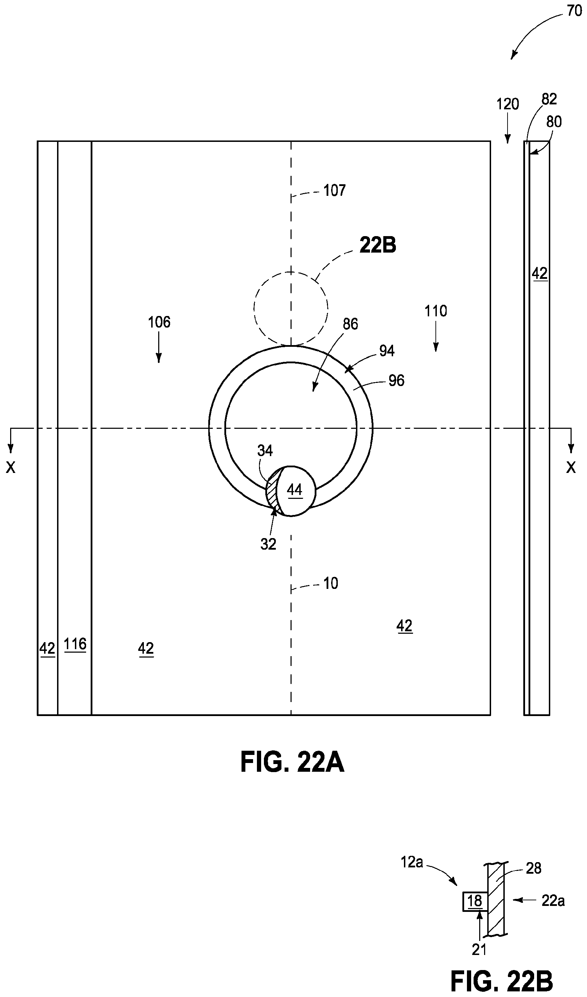

Referring to FIGS. 22 and 22A, the first electrode material 28 is formed within the voids 122 and patterned into the first electrodes 22a and 22b. Sacrificial material 126 is provided within the voids 122 and along the electrode material 28 to assist in the patterning of the electrode material 28 into the configuration of the first electrodes 22a and 22b. The sacrificial material 126 may comprise any suitable composition(s), and in some embodiments may comprise an oxide formed at sufficiently low temperature such that components associated with circuitry of the assembly 70 are not degraded.

The voids 122 extend about halfway around the opening 86, and the dashed line 107 is provided to show approximate edges of the voids 122. FIG. 22B shows a region along one of the levels 76, and shows the electrode 22a directly contacting semiconductor material 18 of the transistor 12a. The region of the semiconductor material 18 which contacts the electrode 22a comprises the first source/drain region 21.

Referring to FIGS. 23 and 23A, the sacrificial material 126 (FIG. 22) is removed. Subsequently, capacitor dielectric material 128 is formed along the electrodes 22a and 22b, and then the electrode material 30 is formed along the capacitor dielectric material 128.

The capacitor dielectric material 128 may comprise any suitable composition(s); such as, for example, one or more of silicon dioxide, silicon nitride, hafnium oxide, zirconium oxide, aluminum oxide, other high-k materials (with high-k meaning a dielectric constant greater than that of silicon dioxide), etc.

The electrode material 30 forms second electrodes 24a and 24b. In the illustrated embodiment, the second electrodes 24a and 24b are electrically coupled to one another in that the conductive material 30 forms a common conductive plate extending across both of the capacitors.

The electrodes 22a and 24a, together with the dielectric material 128 therebetween, form the capacitor 14a; and the electrodes 22b and 24b, together with the dielectric material 128 therebetween, form the capacitor 14b.

The transistor 12a and the capacitor 14a together form a device 10a along one of the device levels 76, and the transistor 12b and the capacitor 14b together form a device 10b along another of the device levels 76. The devices 10a and 10b are vertically offset relative to one another (i.e., are vertically stacked).

In some embodiments, the opening 86 may be representative of a plurality of openings, as discussed above. In such embodiments, the devices 10a and 10b may be representative of a plurality of devices that may be formed relative to each of the openings. Such devices may be memory devices, and may form memory arrays; such as, for example, arrays 50 of the type described above with reference to FIGS. 6 and 7. Each of the memory devices within the memory arrays may be uniquely addressed through a combination of a wordline and a digit line, as discussed above relative to the memory arrays 50 of FIGS. 6 and 7.

In the embodiment of FIG. 23, each device (for instance, device 10a) comprises a transistor (e.g., transistor 12a) coupled with an associated capacitor (e.g., capacitor 14a). The capacitor is horizontally offset from the transistor; and both the transistor and the associated capacitor are within a single device level 76. The devices may be within a memory array 50 of the type described above with reference to FIG. 6. Wordlines (e.g., wordlines 36a, 36b) extend along the device levels 76 and are coupled with gates of the transistors 12a, 12b; and digit lines (e.g., digit line 32) extend vertically through the device levels are coupled with source/drain regions of the transistors 12a, 12b.

In some embodiments, each of the devices (e.g., devices 10a, 10b) of FIG. 23 may be considered to be between a first insulative level 74 below the device, and a second insulative level 74 above the device.

FIG. 23 shows the insulative level 74 above device 10a being labeled as a level 74a, and shows the insulative level 74 below device 10a being labeled as level 74b. The level 74a has a bottom surface 127, and the level 74b has a top surface 129. The capacitor of the device 10a (i.e., capacitor 14a) has an uppermost surface 131 and a lowermost surface 133; and the transistor of the device 10a (i.e., transistor 12a) has an uppermost surface 135 and a lowermost surface 137. The uppermost surfaces 135 and 131 of the transistor 12a and the capacitor 14a are at the same elevational level as one another beneath the bottom surface 127 of upper insulative level 74a; and the lowermost surfaces 137 and 133 of the transistor 12a and the capacitor 14a are at the same elevational level as one another above the upper surface 129 of the lower insulative level 74b.

In some examples, the capacitor 14a may have a lowermost surface 133 which is at least as far below the lowermost surface 127 of the insulative level 74a as the lowermost surface 137 of the transistor 12a, and may have an uppermost surface 131 which is at least as far above the uppermost surface 129 of the insulative level 74b has the uppermost surface 135 of the transistor 12a. If the top surface of the capacitor is no lower than the top surface of the transistor, and if the bottom surface of the capacitor is also no higher than the bottom surface of the transistor, then the transistor 12a and the capacitor 14a may be considered to be in the same planar level as one another (i.e., if the vertical dimension of the transistor is vertically coextensive with the vertical dimension of the capacitor, or vertically sandwiched between the upper and lower surfaces of the capacitor). Alternatively, the transistor 12a and the capacitor 14a may be considered to be in the same planar level as one another if the top surface of the transistor is no lower than the top surface of the capacitor, and the bottom surface of the transistor is no higher than the bottom surface of the transistor (i.e., if the vertical dimension of the capacitor is vertically coextensive with the vertical dimension of the transistor, or vertically sandwiched between the upper and lower surfaces of the transistor).

It is to be understood that the invention described herein may be applicable to numerous circuit designs, including, but not limited to memory arrays. Example circuits may include layouts which may have pillars and/or other structures associated, with, for example, transistors, isolation, gates, capacitors, etc. The example circuits may include multiple layers in one or more tier stacks. Example circuits may be one large connected structure, or may be multiple separated structures (e.g., multiple individual thin substrates).

The structures discussed above may be incorporated into electronic systems. Such electronic systems may be used in, for example, memory modules, device drivers, power modules, communication modems, processor modules, and application-specific modules, and may include multilayer, multichip modules. The electronic systems may be any of a broad range of systems, such as, for example, cameras, wireless devices, displays, chip sets, set top boxes, games, lighting, vehicles, clocks, televisions, cell phones, personal computers, automobiles, industrial control systems, aircraft, etc.

Unless specified otherwise, the various materials, substances, compositions, etc. described herein may be formed with any suitable methodologies, either now known or yet to be developed, including, for example, atomic layer deposition (ALD), chemical vapor deposition (CVD), physical vapor deposition (PVD), etc.

The terms "dielectric" and "insulative" may be utilized to describe materials having insulative electrical properties. The terms are considered synonymous in this disclosure. The utilization of the term "dielectric" in some instances, and the term "insulative" (or "electrically insulative") in other instances, may be to provide language variation within this disclosure to simplify antecedent basis within the claims that follow, and is not utilized to indicate any significant chemical or electrical differences.

The particular orientation of the various embodiments in the drawings is for illustrative purposes only, and the embodiments may be rotated relative to the shown orientations in some applications. The descriptions provided herein, and the claims that follow, pertain to any structures that have the described relationships between various features, regardless of whether the structures are in the particular orientation of the drawings, or are rotated relative to such orientation.

The cross-sectional views of the accompanying illustrations only show features within the planes of the cross-sections, and do not show materials behind the planes of the cross-sections, unless indicated otherwise, in order to simplify the drawings.

When a structure is referred to above as being "on" or "against" another structure, it can be directly on the other structure or intervening structures may also be present. In contrast, when a structure is referred to as being "directly on" or "directly against" another structure, there are no intervening structures present.

Structures (e.g., layers, materials, etc.) may be referred to as "extending vertically" to indicate that the structures generally extend upwardly from an underlying base (e.g., substrate). The vertically-extending structures may extend substantially orthogonally relative to an upper surface of the base, or not.

For the avoidance of doubt, the scope of the invention is defined by the appended claims.

## Claims

1. An assembly comprising:
a stack (72) of first (74) and second levels (76) which alternate with one another along a vertical direction over a semiconductor base (84);
the first levels (74) comprising insulative material and being insulative levels,
the second levels (76) being device levels comprising devices, wherein
each of the devices (10) includes a transistor (12) coupled with a capacitor (14); the capacitor (14) being horizontally offset relative to the transistor (12); the capacitor (14) and the transistor (12) being in a same planar level as one another; wherein the transistor (12) includes a transistor gate (16) proximate a channel region (17), and wherein the transistor gate (16) brackets the channel region (17);
wherein the capacitor (14) of each device has an uppermost surface (131) and a lowermost surface (133), and the transistor (12) of each device has an uppermost surface (135) and a lowermost surface (137); and
wherein the uppermost surface (135) of the transistor (12) and the uppermost surface (131) of the capacitor (14) are at the same elevational level as one another and the lowermost surface (137) of the transistor (12) and the lowermost surface (133) of the capacitor (14) are at the same elevational level as one another,
the capacitor (14) and the transistor (12) of each of the devices (10) being entirely contained within one of the device levels (76).

2. The assembly of claim 1, wherein at least one of the devices (10) is substantially circular along a horizontal cross-section through the device.

3. The assembly of claim 1, wherein at least one of the devices (10) is not substantially circular along a horizontal cross-section through the device.

4. The assembly of claim 1, wherein:
the transistors (12) comprise semiconductor channel material (18), the semiconductor channel material including the channel region (17), wherein the transistor gates (16) are along the semiconductor channel material (18); each of the transistors (12) comprises a first source/drain region (21) along one side of the semiconductor channel material (18) and coupled with the associated capacitor (14), and comprises a second source/drain region (19) on an opposing side of the semiconductor channel material (18) from said first source/drain region (21); and
the assembly further comprises:
wordlines (36) extending horizontally along the device levels (76) and being coupled with the transistor gates (16); and
digit lines (32) extending vertically through the device levels (76) and being coupled with the second source/drain regions (19) of the transistors (12).

5. The assembly of claim 4, wherein at least some of the devices (10) within one of the device levels (76) are identical to at least some of the devices (10) within at least one other of the device levels (76).

6. The assembly of claim 4, wherein at least some of the devices (10) within one of the device levels (76) are not identical to at least some of the devices (10) within another of the device levels (76).

7. The assembly of claim 6, wherein said at least some of the devices (10) within said one of the device levels (76) differ from said at least some of the devices (10) in said other of the device levels (76) in one or more properties of the semiconductor channel material (18).

8. The assembly of claim 4, wherein at least one of the digit lines (32) is substantially circular along a horizontal cross-section through said at least one of the digit lines (32).

9. The assembly of claim 4, wherein at least one of the digit lines (32) is crescent-shaped along a horizontal cross-section through said at least one of the digit lines (32).

## Patentansprüche

1. Anordnung, umfassend:
einen Stapel (72) erster (74) und zweiter Ebenen (76), die sich entlang einer vertikalen Richtung über einer Halbleiterbasis (84) abwechseln;
wobei die ersten Ebenen (74) isolierendes Material umfassen und isolierende Ebenen sind,
die zweiten Ebenen (76) Vorrichtungsebenen sind, die Vorrichtungen umfassen, wobei
jede der Vorrichtungen (10) einen Transistor (12) einschließt, der mit einem Kondensator (14) gekoppelt ist; der Kondensator (14) horizontal relativ zum Transistor (12) versetzt ist; der Kondensator (14) und der Transistor (12) in einer selben planaren Ebene liegen; wobei der Transistor (12) ein Transistor-Gate (16) nahe einem Kanalbereich (17) einschließt und wobei das Transistor-Gate (16) den Kanalbereich (17) einklammert;
wobei der Kondensator (14) jeder Vorrichtung eine oberste Oberfläche (131) und eine unterste Oberfläche (133) aufweist und der Transistor (12) jeder Vorrichtung eine oberste Oberfläche (135) und eine unterste Oberfläche (137) aufweist; und
wobei die oberste Oberfläche (135) des Transistors (12) und die oberste Oberfläche (131) des Kondensators (14) auf derselben Höhenebene liegen und die unterste Oberfläche (137) des Transistors (12) und die unterste Oberfläche (133) des Kondensators (14) auf derselben Höhenebene liegen,
der Kondensator (14) und der Transistor (12) jeder der Vorrichtungen (10) vollständig in einer der Vorrichtungsebenen (76) enthalten ist.

2. Anordnung nach Anspruch 1, wobei mindestens eine der Vorrichtungen (10) entlang eines horizontalen Querschnitts durch die Vorrichtung im Wesentlichen kreisförmig ist.

3. Anordnung nach Anspruch 1, wobei mindestens eine der Vorrichtungen (10) entlang eines horizontalen Querschnitts durch die Vorrichtung im Wesentlichen nicht kreisförmig ist.

4. Anordnung nach Anspruch 1, wobei:
die Transistoren (12) Halbleiterkanalmaterial (18) umfassen, wobei das Halbleiterkanalmaterial den Kanalbereich (17) einschließt, wobei die Transistor-Gates (16) entlang des Halbleiterkanalmaterials (18) verlaufen; jeder der Transistoren (12) einen ersten Source/Drain-Bereich (21) entlang einer Seite des Halbleiterkanalmaterials (18) und mit dem zugehörigen Kondensator (14) gekoppelt umfasst und einen zweiten Source/Drain-Bereich (19) an einer gegenüberliegenden Seite des Halbleiterkanalmaterials (18) des ersten Source/Drain-Bereichs (21) umfasst; und
die Anordnung ferner umfasst:
Wortleitungen (36), die sich horizontal entlang der Vorrichtungsebenen (76) erstrecken und mit den Transistor-Gates (16) gekoppelt sind; und
Ziffernleitungen (32), die sich vertikal durch die Vorrichtungsebenen (76) erstrecken und mit den zweiten Source/Drain-Bereichen (19) der Transistoren (12) gekoppelt sind.

5. Anordnung nach Anspruch 4, wobei mindestens einige der Vorrichtungen (10) innerhalb einer der Vorrichtungsebenen (76) identisch mit mindestens einigen der Vorrichtungen (10) innerhalb mindestens einer anderen der Vorrichtungsebenen (76) sind.

6. Anordnung nach Anspruch 4, wobei mindestens einige der Vorrichtungen (10) innerhalb einer der Vorrichtungsebenen (76) nicht identisch mit mindestens einigen der Vorrichtungen (10) innerhalb einer anderen der Vorrichtungsebenen (76) sind.

7. Anordnung nach Anspruch 6, wobei die mindestens einigen der Vorrichtungen (10) innerhalb der einen der Vorrichtungsebenen (76) sich von den mindestens einigen der Vorrichtungen (10) in der anderen der Vorrichtungsebenen (76) in einer oder mehreren Eigenschaften des Halbleiterkanalmaterials (18) unterscheiden.

8. Anordnung nach Anspruch 4, wobei mindestens eine der Ziffernleitungen (32) entlang eines horizontalen Querschnitts durch die mindestens eine der Ziffernleitungen (32) im Wesentlichen kreisförmig ist.

9. Anordnung nach Anspruch 4, wobei mindestens eine der Ziffernleitungen (32) entlang eines horizontalen Querschnitts durch die mindestens eine der Ziffernleitungen (32) sichelförmig kreisförmig ist.

## Revendications

1. Ensemble comprenant :
une pile (72) de premiers (74) et deuxièmes niveaux (76) qui alternent les uns avec les autres le long d'un sens vertical sur une base semi-conductrice (84) ;
les premiers niveaux (74) comprenant un matériau isolant et étant des niveaux isolants,
les deuxièmes niveaux (76) étant des niveaux de dispositif comprenant des dispositifs, dans lequel
chacun des dispositifs (10) inclut un transistor (12) couplé à un condensateur (14) ; le condensateur (14) étant décalé horizontalement par rapport au transistor (12) ; le condensateur (14) et le transistor (12) étant dans un même niveau planaire l'un que l'autre ; dans lequel le transistor (12) inclut une grille de transistor (16) proche d'une région de conduit (17), et dans lequel la grille de transistor (16) encadre la région de conduit (17) ;
dans lequel le condensateur (14) de chaque dispositif présente une surface la plus haute (131) et une surface la plus basse (133), et le transistor (12) de chaque dispositif présente une surface la plus haute (135) et une surface la plus basse (137) ; et
dans lequel la surface la plus haute (135) du transistor (12) et la surface la plus haute (131) du condensateur (14) sont au même niveau d'élévation l'une que l'autre et la surface la plus basse (137) du transistor (12) et la surface la plus basse (133) du condensateur (14) sont au même niveau d'élévation l'une que l'autre,
le condensateur (14) et le transistor (12) de chacun des dispositifs (10) étant intégralement contenus dans l'un des niveaux de dispositif (76).

2. Ensemble selon la revendication 1, dans lequel au moins un des dispositifs (10) est sensiblement circulaire le long d'une section transversale horizontale traversant le dispositif.

3. Ensemble selon la revendication 1, dans lequel au moins un des dispositifs (10) n'est pas sensiblement circulaire le long d'une section transversale horizontale traversant le dispositif.

4. Ensemble selon la revendication 1, dans lequel :
les transistors (12) comprennent un matériau de conduit semi-conducteur (18), le matériau de conduit semi-conducteur incluant la région de conduit (17), dans lequel les grilles de transistor (16) sont le long du matériau de conduit semi-conducteur (18) ; chacun des transistors (12) comprend une première région de source/drain (21) le long d'un côté du matériau de conduit semi-conducteur (18) et couplée au condensateur (14) associé, et comprend une deuxième région de source/drain (19) sur un côté opposé du matériau de conduit semi-conducteur (18) par rapport à ladite première région de source/drain (21) ; et
l'ensemble comprend en outre :
des lignes de mots (36) s'étendant horizontalement le long des niveaux de dispositif (76) et étant couplées aux grilles de transistor (16) ; et
des lignes de chiffres (32) s'étendant verticalement à travers les niveaux de dispositif (76) et étant couplées aux deuxièmes régions de source/drain (19) des transistors (12).

5. Ensemble selon la revendication 4, dans lequel au moins certains des dispositifs (10) à l'intérieur d'un des niveaux de dispositif (76) sont identiques à au moins certains des dispositifs (10) à l'intérieur d'au moins un autre des niveaux de dispositif (76).

6. Ensemble selon la revendication 4, dans lequel au moins certains des dispositifs (10) à l'intérieur d'un des niveaux de dispositif (76) ne sont pas identiques à au moins certains des dispositifs (10) à l'intérieur d'un autre des niveaux de dispositif (76).

7. Ensemble selon la revendication 6, dans lequel lesdits au moins certains des dispositifs (10) à l'intérieur dudit un des niveaux de dispositif (76) diffèrent desdits au moins certains des dispositifs (10) dans ledit autre des niveaux de dispositif (76) par une ou plusieurs propriétés du matériau de conduit semi-conducteur (18).

8. Ensemble selon la revendication 4, dans lequel au moins une des lignes de chiffres (32) est sensiblement circulaire le long d'une section transversale horizontale traversant ladite au moins une des lignes de chiffres (32).

9. Ensemble selon la revendication 4, dans lequel au moins une des lignes de chiffres (32) est en forme de croissant le long d'une section transversale horizontale traversant ladite au moins une des lignes de chiffres (32).
